# EUROPEAN PATENT SPECIFICATION

(11) **EP 3 254 311 B1**
(45) Date of publication and mention of the grant of the patent: **30.10.2019**
(21) Application number: 16704996.4
(22) Date of filing: 01.02.2016
(51) Int. Cl.: H01L 27/146

(54) **CMOS DEPTH IMAGE SENSOR WITH INTEGRATED SHALLOW TRENCH ISOLATION STRUCTURES**
CMOS-TIEFENBILDSENSOR MIT INTEGRIERTEN FLACHEN GRABENISOLATIONSSTRUKTUREN
CAPTEUR D'IMAGE DE PROFONDEUR CMOS À STRUCTURES DE TRANCHÉE D'ISOLATION PEU PROFONDE INTÉGRÉES

(30) Priority: 03.02.2015 US 201562111515 P; 30.06.2015 US 201514788235
(43) Date of publication of application: 13.12.2017
(73) Proprietor: Microsoft Technology Licensing, LLC, Redmond, Washington 98052-6399 (US)
(72) Inventor: ELKHATIB, Tamer, Redmond, Washington 98052-6399 (US); AKKAYA, Onur Can, Redmond, Washington 98052-6399 (US); MEHTA, Swati, Redmond, Washington 98052-6399 (US); BAMJI, Cyrus, Redmond, Washington 98052-6399 (US)
(74) Representative: CMS Cameron McKenna Nabarro Olswang LLP
(86) International application number: PCT/US2016/015865
(87) International publication number: WO 2016/126562

(56) References cited:
- EP-A2- 2 216 818
- US-A1- 2009 008 735
- US-A1- 2012 267 694
- US-A1- 2012 273 910

## Description

### BACKGROUND

CMOS image sensors have become increasingly popular in applications such as digital cameras, including still image and video cameras used in personal computers, laptops and smart phones. A special type of these image sensors has also been used in depth cameras. A depth camera is able to determine the distance to a human or other object in a field of view of the camera, and to update the distance substantially in real time based on a frame rate of the camera. Such a depth camera can be used in a motion capture system, for instance, to obtain data regarding the location and movement of a human body or other subject in a physical space, for input to an application in a computing system. Many applications are possible, such as for military, entertainment, sports and medical purposes. One type of a depth camera is a CMOS time-of-flight image sensor. A time-of-flight (ToF) depth camera typically includes a modulated near infrared (or infrared) light source which illuminates the field of view, and a CMOS ToF image sensor which senses reflected light from the field of view and measures the phase shift between illuminated and reflected light to form a depth image. In some cases, the depth camera can be provided as part of a gaming console which communicates with a display device such as a television in a user's home.

US 2012/0273910 A1 (Hochschultz et al.) discloses a photodetector for detecting impinging radiation comprising a layer thickness and/or refractive index variation for realizing different internal optical path lengths for the impinging radiation, in order to reduce fluctuation of the spectral sensitivity of the photodetector. In an example, a detector is implemented as a photodiode having one pn transition in one substrate on which one optical stack of dielectric layers is located. One of the dielectric layers close to the pn transition is a thermal oxide, which may be formed by a LOCOS or a STI process, and may be realized by an interleaved arrangement of small areas. US 2012/0267694 A1 (Kaiser et al.) discloses an integrated circuit arrangement for an image sensor which includes a transistor including a gate region, and a wavelength conversion element above a carrier. The wavelength conversion element is disposed over the photoconverter comprised by the carrier. In an embodiment, STI isolation structures are arranged between photoconverters to avoid color mixing.

### SUMMARY

Several aspects of the invention provide a CMOS image sensor as set forth in claim 1 and a method as set forth in claim 10. In an example, a photodetector area of a pixel in a CMOS image sensor such as a CMOS time-of-flight image sensor comprises a photosensitive semiconductor layer with an integrated shallow trench isolation structure. The photosensitive semiconductor layer converts incident light into electrical charges and includes one or more photosensitive structures such as PN-junction photodiodes, PIN photodiodes, pinned photodiodes, or photogates. The shallow trench isolation structure acts as an optical grating that modifies incident light by reflection, deflection and/or diffraction at its interface and re-distributes the incident light inside the photosensitive semiconductor area. This redistribution of optical energy results in higher optical sensitivity at desired light illuminating wavelengths. In addition, the shallow trench isolation structure acts electrically as a physical barrier to the movement of electric charges between different photosensitive structures within a time-of-flight photodetector. Hence, a higher modulation contrast is observed.

Moreover, increases in dark current are avoided by passivating the shallow trench isolation structure with dopant which is already used in the semiconductor layer as a part of the pixel design. Heating of the substrate causes the dopant to diffuse toward the walls of the shallow trench isolation structures. Further, front side or backside illumination can be used.

In one embodiment, a CMOS image sensor pixel comprises a photosensitive semiconductor layer such as an epitaxial layer of a silicon substrate. The epitaxial layer comprises one or more photosensitive structures (e.g., photodiodes or photogates) to convert incident light into electrical charges. One or more pixel charge collector nodes are configured to collect the electrical charges. Additionally, an integrated shallow trench isolation (STI) structure is configured to modify the incident light at an interface of the photosensitive semiconductor layer by at least one of diffraction, deflection or reflection, to redistribute the incident light within the photosensitive semiconductor layer to improve an optical sensitivity of the pixel. The improvement is relative to a same structure in which the integrated STI structure is not present.

In one approach, multiple STI structures are spaced apart from one another in a first direction in the substrate, thereby forming a diffraction grating extending in the first direction (e.g., in a one-dimensional or 1-D grating). Further, a STI structure may have a varying width in a second direction, perpendicular to the first direction, so that a diffraction effect is also provided in the second direction (e.g., in a two-dimensional or 2-D grating). In another example of a 2-D grating, multiple distinct STI structures are spaced apart from one another in the second direction as well as in the first direction.

The pixel provides an increased optical sensitivity in a CMOS image sensor at near infrared wavelengths. In a time-of-flight sensor, the pixel provides an increased modulation contrast. Moreover, the pixel may be fabricated using CMOS fabrication techniques.

This summary is provided to introduce a selection of concepts in a simplified form that are further described below in the description. This summary is not intended to identify key features or essential features of the claimed subject matter, nor is it intended to be used to limit the scope of the claimed subject matter.

### BRIEF DESCRIPTION OF THE DRAWINGS

In the drawings, like-numbered elements correspond to one another.
FIG. 1A depicts an example of a depth camera which uses an image sensor such as described herein.
FIG. 1B depicts the high frequency component of an exemplary idealized periodic optical energy signal in the depth camera of FIG. 1A.
FIG. 1C depicts the returned version of the transmitted waveform in the depth camera of FIG. 1A.
FIG. 1D depicts a cross-sectional view of a CMOS image sensor showing a photosensitive semiconductor layer 111, a photodiode 113, a photogate 114, a dielectric insulating material 110 and a substrate 112.
FIG. 1E depicts a cross-sectional view of a CMOS image sensor showing a photosensitive semiconductor layer 111 in which one photodiode is integrated with STI structures.
FIG. 1F depicts a cross-sectional view of a CMOS image sensor showing a photosensitive semiconductor layer 111 in which different photodiodes are integrated with STI structures.
FIG. 1G depicts a cross-sectional view of a CMOS image sensor showing a photosensitive semiconductor layer 111 in which different photogates and doped regions are integrated with STI structures.
FIG. 2A depicts a top view of a pixel in an image sensor, where the pixel includes four elongated gate electrodes and shallow trench isolation (STI) structures between the gate electrodes, and the STI structures for a 1-D diffraction grating.
FIG. 2B depicts a cross-sectional view along line 210 of the pixel of FIG. 2A.
FIG. 2C depicts a top view of a pixel in an image sensor, where STI structures between the gate electrodes have a varying width to form a 2-D diffraction grating and different rows of the STI structures are uniform.
FIG. 2D depicts an expanded view of a portion of the trench T2a of FIG. 2C.
FIG. 2E depicts another example of a pixel, where STI structures are spaced apart from one another in an x-direction and a y-direction to form a 2-D diffraction grating.
FIG. 2F depicts another example of a pixel, where STI structures are spaced apart from one another in an x-direction to form a 1-D diffraction grating, and two STI structures are provided between adjacent gate electrodes.
FIG. 2G depicts another example of a pixel, where STI structures are spaced apart from one another in an x-direction and a y-direction to form a 2-D diffraction grating, and two rows of STI structures are provided between adjacent gate electrodes.
FIG. 2H depicts another example of a pixel, where STI structures are spaced apart from one another in an x-direction and have a varying width in a y-direction to form a 2-D diffraction grating, and different rows of the STI structures are non-uniform.
FIG. 2I depicts another example of a pixel, where STI structures are spaced apart from one another in an x-direction and a y-direction to form a 2-D diffraction grating, and different rows of the STI structures are non-uniform.
FIG. 3A depicts a plot of modulation contrast versus trench width for the pixel of FIG. 2A and 2B.
FIG. 3B depicts a plot of optical generation versus depth in substrate, for the pixel of FIG. 2A and 2B and a comparable pixel which does not have the STI structures.
FIG. 3C depicts optical generation in the substrate for a comparable pixel which does not have the STI structures, with a substrate depth on the vertical axis and a horizontal (x-axis) dimension along the horizontal axis.
FIG. 3D depicts optical generation in the substrate of the pixel of FIG. 2A and 2B, with a substrate depth on the vertical axis and a horizontal (x-axis) dimension along the horizontal axis.
FIG. 4 depicts a process for fabricating an image sensor which includes the pixel of FIG. 2A.
FIG. 5A depicts a cross-sectional view of a pixel according to step 401 of FIG. 4.
FIG. 5B depicts a cross-sectional view of a pixel according to step 402 of FIG. 4.
FIG. 5C depicts a cross-sectional view of a pixel according to step 403 of FIG. 4.
FIG. 5D depicts a cross-sectional view of a pixel according to step 404 of FIG. 4.
FIG. 5E depicts a cross-sectional view of a pixel according to steps 405 and 406 of FIG. 4.
FIG. 5F depicts a cross-sectional view of a pixel according to step 407 of FIG. 4.
FIG. 5G depicts a cross-sectional view of a pixel according to step 408 of FIG. 4.
FIG. 5H depicts a cross-sectional view of a pixel according to step 409 and 410 of FIG. 4.
FIG. 5I depicts an expanded view of a portion of the pixel of FIG. 5H.
FIG. 6A depicts an example pixel in which STI structures are on a side of the epitaxial layer which faces the micro lens, in a front side illumination design.
FIG. 6B depicts an example pixel in which STI structures are on a side of the epitaxial layer which faces away from the micro lens, in one example of a back side illumination design.
FIG. 6C depicts an example pixel in which STI structures are on a side of the epitaxial layer which faces away from the micro lens, and on an opposing side of the epitaxial layer which faces the micro lens, in another example of a back side illumination design.
FIG. 7A depicts a plot of the redistribution of optical generation or absorption in the epitaxial layer by adding the STI structure in an example front side illumination design.
FIG. 7B depicts a plot of an improvement in quantum efficiency due to the STI structure, consistent with FIG. 7A.
FIG. 7C depicts a plot of the redistribution of optical generation (absorption) in the epitaxial layer by adding the STI structure in another example front side illumination design.
FIG. 7D depicts a plot of an improvement in quantum efficiency due to the STI structure, consistent with FIG. 7C.
FIG. 7E depicts a plot of absorption versus wavelength, showing an increase in absorption due to the STI structure.

### DETAILED DESCRIPTION

The performance of a CMOS time-of-flight image sensor such as a phase-modulated time-of-flight sensor can be characterized by modulation contrast and optical sensitivity. Both of these metrics should be as high as possible for best performance.

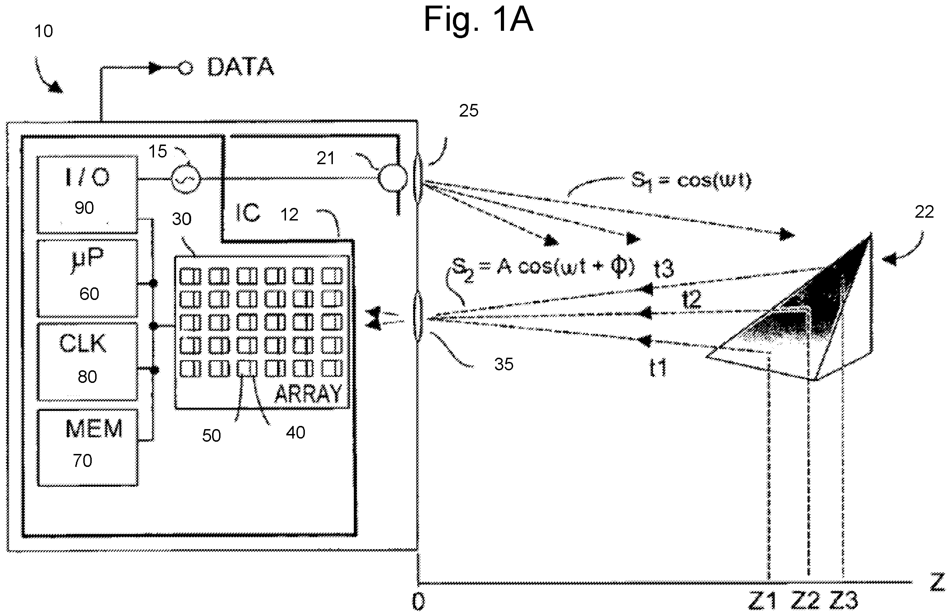

FIG. 1A depicts an example of a depth camera 10 which uses an image sensor such as described herein. The depth camera is configured as a ToF system and can be implemented on a single integrated circuit (IC) 12, without moving parts and with relatively few off-chip components. The depth camera includes a two-dimensional array 30 of pixel detectors 40, each of which has dedicated circuitry 50 for processing detection charge output by the associated detector. In a typical application, the array might include 100×100 pixels, and thus include 100×100 processing circuits. The IC also includes a microprocessor or microcontroller unit 60, a memory 70 (e.g., random access memory and read-only memory), a high speed distributable clock 80, and various computing and input/output (I/O) circuitry 90. Among other functions, microcontroller unit 60 may perform distance to object and object velocity calculations.

Under control of the microprocessor, a source of optical energy (emitter 21) is periodically energized and emits optical energy via lens 25 toward a target object 22. Typically the optical energy is light, for example emitted by a laser diode or LED device. Some of the emitted optical energy will be reflected off the surface of target object, and will pass through an aperture field stop and lens, collectively 35, and will fall upon a two-dimensional array 30 of photo detectors 40 where an image is formed. Each imaging pixel detector measures both intensity or amplitude of the optical energy received, and the phase-shift of the optical energy as it travels from emitter 21, through distance Z to the target object, and then distance again back to the imaging sensor array. For each pulse of optical energy transmitted by the emitter, a three-dimensional image of the visible portion of target object is acquired.

Emitted optical energy traversing to more distant surface regions of target object before being reflected back toward the depth camera will define a longer time-of-flight than radiation falling upon and being reflected from a nearer surface portion of the target object (or a closer target object). For example the time-of-flight for optical energy to traverse the roundtrip path noted at t1 is given by t1=2·Z1/C, where C is velocity of light. A TOF sensor system can acquire three-dimensional images of a target object in real time. Such systems advantageously can simultaneously acquire both luminosity data (e.g., signal amplitude) and true TOF distance measurements of a target object or scene.

In one embodiment of the depth camera, each pixel detector has an associated high speed counter that accumulates clock pulses in a number directly proportional to TOF for a system-emitted pulse to reflect from an object point and be detected by a pixel detector focused upon that point. The TOF data provides a direct digital measure of distance from the particular pixel to a point on the object reflecting the emitted pulse of optical energy. In another embodiment, in lieu of high speed clock circuits, each pixel detector is provided with a charge accumulator and an electronic shutter. The shutters are opened when a pulse of optical energy is emitted, and closed thereafter such that each pixel detector accumulates charge as a function of return photon energy falling upon the associated pixel detector. The amount of accumulated charge provides a direct measure of round-trip TOF. In either embodiment, TOF data permits reconstruction of the three-dimensional topography of the light-reflecting surface of the object being imaged.

An oscillator 15 is controllable by the microprocessor to emit high frequency (perhaps 200 MHz) component periodic signals, ideally representable as A·cos(ωt). The emitter 21 transmits optical energy having a low average and peak power in the tens of mW range. Such emitted signals allow use of inexpensive light sources and simpler, narrower bandwidth (e.g., a few hundred KHz) pixel detectors 40.

In this system, there will be a phase shift ϕ due to the time-of-flight (ToF) required for energy transmitted by the emitter (S1=cos(ωt)) to traverse distance z to a target object 22, and the return energy detected by a photo detector 40 in the array 30, S2=A·cos(ωt+ϕ), where A represents brightness of the detected reflected signal and may be measured separately using the same return signal that is received by the pixel detector.

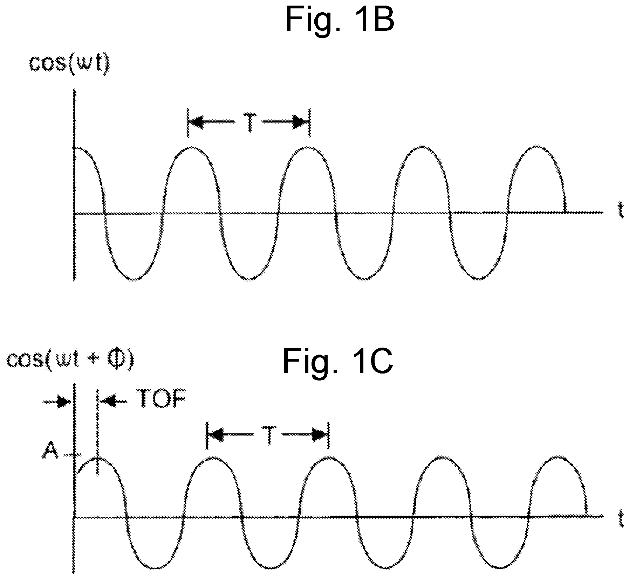

FIGS. 1B and 1C depict the relationship between phase shift ϕ and time-of-flight, again assuming for ease of description a sinusoidal waveform. In an alternative approach, a square wave is used. The period for the waveforms is T=2π/ω. The phase shift ϕ due to time-of-flight is: ϕ=2·ω·z/C=2·(2πf)·z/C, where C is the speed of light (300,000 Km/sec). Thus, a distance z from the energy emitter (and from the detector array) to the target object is given by: z=ϕ·C/2ω=ϕ·C/{2·(2πf)}.

FIG. 1B depicts the high frequency component of an exemplary idealized periodic optical energy signal, here a signal represented as cos(ωt). The period T of the waveform shown is T=2π/ω. The signal is depicted as though it were AC-coupled in that any magnitude offset is not present. The operative frequency of the transmitted signal may be in the few hundred MHz range, and the average and the peak transmitted power may be relatively modest, e.g., less than about 50 mW or so. A portion of the transmitted energy reaches a target object and is at least partially reflected back toward the depth camera to be detected.

FIG. 1C depicts the returned version of the transmitted waveform, denoted A·cos(ωt+ϕ), where A is an attenuation coefficient, and ϕ is a phase shift resulting from the time-of-flight (TOF) of the energy in traversing the distance from the '496 invention to the target object. Knowledge of the time of flight provides the distance z from a point on the target object to the recipient pixel detector in the array of detectors.

Another example of a 3D depth camera system can include a structured light depth camera, with a near infrared projected pattern and a general CMOS image sensor configured to operate at these wavelengths.

The sensor converts the incident light to an electrical current which can be measured to detect a distance to the object.

One simplified definition of modulation contrast is (Sin -Sout)/(Sin+Sout), where Sin is the detected light signal from the sensor when the reflected modulated light is in phase with a reference modulated signal and Sout is the detected light signal from the sensor when the reflected modulated light is out of phase with a reference modulated signal. A variance in the depth measurement is lower when the modulation contrast is higher. Optical sensitivity generally refers to an amount of increase in the electrical current based on an amount of increase in the incident light. Quantum Efficiency can measure the sensor optical sensitivity and it is defined as the ratio of the number of charge carriers collected by the sensor to the number of photons of a given energy illuminating the sensor.

A higher modulation contrast at higher frequencies and a better optical sensitivity result in a better extracted depth quality, a larger depth operation range and a lower power consumption. Techniques provided herein improve modulation contrast and optical sensitivity without any significant increase in cost or complexity.

Typically a CMOS image sensor is fabricated in a substrate in which the upper portion of the substrate is an epitaxial layer with relatively low doping. The epitaxial layer is generally the photosensitive semiconductor layer of the sensor. The incident light radiation that is not absorbed in this epitaxial layer is considered as lost optical energy. The length of this epitaxial layer can be, e.g., a few microns (1-10um) while the optical absorption depth at long wavelengths (red, near infrared, and infrared) can be as few as tens of microns. Hence, most of the standard CMOS image sensors suffer from lower optical sensitivity (quantum efficiency) at these long wavelengths. The techniques provided herein address the above and other issues.

In one aspect, a CMOS image sensor comprises integrated STI structures in the epitaxial layer of a pixel that improve the optical sensitivity (quantum efficiency) of the sensor. In one approach, this CMOS image sensor can be configured as a time-of-flight sensor to measure the depth between an object and the sensor.

A concern is that dark current can be generated at an interface between oxide and silicon due to interface traps. For a trench, the sidewalls are such an interface. To avoid dark current in the substrate, the walls of the STI structures are passivated with a dopant at a certain doping level. This minimizes the dark current which could otherwise be induced by the STI structures.

The improved optical sensitivity which is achieved is applicable to any type of CMOS photodetector and, particularly, any CMOS image sensor for red and near-infrared wavelengths in which the silicon absorption half path length is much longer than the portion of the epitaxial layer of the substrate which is used to detect light in the image sensor wafer. The half path length is the thickness of the epitaxial layer in which the magnitude of the incident light is reduced by one half. In other words, the improved optical sensitivity is achieved in portions of the epitaxial layer in which the incident light is not highly attenuated.

The techniques enhance the optical sensitivity at red and near-infrared wavelengths for time-of-flight image sensors and other CMOS image sensors by using one dimensional and two-dimensional STI structures inside the photodetector area. This STI structure comprises insulating dielectric material fabricated in a standard CMOS process. A first refractive index of the STI structure is different from a second refractive index of the surrounding epitaxial layer. Moreover, the STI structure may comprise a dielectric material having a first dielectric constant, while the epitaxial layer of the photosensitive semiconductor layer, which surrounds the STI structure, has a second dielectric constant which is different than the first dielectric constant. Hence, the STI structure acts as 1-D or 2-D optical grating that diffracts, deflects and/or reflects the incident optical radiation within the epitaxial layer, allowing redistribution of the optical energy in the photosensitive layer in the pixel. Moreover, enhanced optical generation is observed in the area surrounding of the STI grating structure.

Other approaches to improving the modulation contrast of a time-of-flight pixel include modifying the doping concentration and the doping distribution inside the photodetector area to maximize the electric field contrast between the different photo generated carrier collector nodes within the photodetector. The carrier collector node can be a PN photodiode, a PIN photodiode, a pinned photodiode or a photogate, for example. A PN diode is a type of semiconductor diode based upon the PN junction. The diode conducts current in only one direction, and it is made by joining a p-type semiconducting layer to an n-type semiconducting layer. A PIN diode is a diode with a wide, undoped intrinsic semiconductor region between a p-type semiconductor and an n-type semiconductor region. The p-type and n-type regions are typically heavily doped because they are used for ohmic contacts. The wide intrinsic region is in contrast to an ordinary PN diode. A pinned photodiode has p+/n/p regions. Specifically, it has a shallow P+ implant in an N type diffusion layer over a P-type epitaxial substrate layer. Pinning refers to Fermi-level pinning, e.g., pinning to a certain voltage level. A photogate is a voltage induced junction using a MOS (metal-oxide-semiconductor) capacitor. A voltage is applied to a doped polysilicon gate, which acts as the metal, to induce a potential well in the silicon substrate.

Another approach to improving the modulation contrast of a time-of-flight pixel involves enabling fast collection of photo-generated carriers inside the entire epitaxial layer by optimizing the gradient of the doping profile in the epitaxial layer. Approaches to improving the optical sensitivity include increasing the epitaxial layer thickness without a significant reduction in modulation contrast. The techniques provided herein can be used apart from or together with these other approaches.

The techniques provided are compatible with Complementary Metal-Oxide semiconductor (CMOS) fabrication processes. CMOS is a technology for constructing integrated circuits. A CMOS image sensor can therefore be implemented using CMOS circuits including metal oxide semiconductor field effect transistors (MOSFETs) for logic functions.

The techniques provided enhance the modulation contrast of a time-of-flight image sensor by introducing STI regions in the area between different photo generated carrier collector nodes within the photodetector, where the STI structure is a physical barrier that helps modulation contrast while allowing electric field lines to pass through it. In addition, the techniques provided enhance the modulation contrast and optical sensitivity simultaneously in a time-of-flight sensor, resulting in a higher performance device.

The STI structure does not substantially increase the photodetector dark current since it is well passivated by a sufficient amount of doping in portions of the substrate which are adjacent to the walls of the STI structure. The passivation of the STI sidewalls results from a natural doping profile of the original image sensor design or an additional doping profile that does not affect the image sensor design.

An image sensor can have its modulation contrast increased in proportion to an amount of its active photodetector area which is consumed by the STI structures. An image sensor can be fabricated using front side or back side illumination. An image sensor can have different numbers of gate electrodes, such as 2, 4, 6 or 8, so that the detector area is different but the same high modulation frequency is achieved. The gate electrodes may be polysilicon and elongated like fingers which extend parallel to one another across the substrate, in one possible approach.

The image sensor can be a CMOS image sensor which operates using time-of-flight or other approaches such as stereo vision or structured light.

The STI structure is a complete physical barrier to movement of carriers (electrons and holes) inside the detector area of the substrate. The use of this physical barrier between gate electrodes instead of a doping barrier facilitates the design of the image sensor. In addition, the STI structure is transparent to electric field lines induced by the gate electrodes, so that the electric field lines can penetrate deeper in the epitaxial layer, enabling stronger and deeper electric modulation fields. Moreover, the STI structures reduce the portion of the top surface of the substrate which is an interface to a gate oxide layer. As a result, problems which are associated with such an interface are reduced. For example, interface traps can cause an undesired induced electric field in the substrate and cause unstable operation, especially when the image sensor is initially powered on.

Further, the reduced area of the top surface of the substrate allows electric field lines to modulate better and deeper in the substrate, especially for red and infrared wavelength light. Therefore, the greater the area of the STI structures at the surface of the substrate, the better the modulation contrast of the image sensor.

In addition, the contrast in the dielectric constant between the STI structures and the surface of the silicon substrate results in a high contrast grating effect of the red and near-infrared wavelengths inside the substrate. This strong grating effect leads to the redistribution of optical energy in the substrate, thereby generating more photo-carriers near the gate electrodes. As a result, an overall observed increase in optical sensitivity has been measured to be 10-15% extra in fabricated chips. Further, optical simulation has demonstrated enhanced optical generation near the surface of the wafer and slightly less optical generation in the deep substrate, compared to the similar non-STI structure. Further optimization of such STI structures in one or two dimensions can lead to even more improvements in optical sensitivity of image sensors for light with relatively long wavelengths.

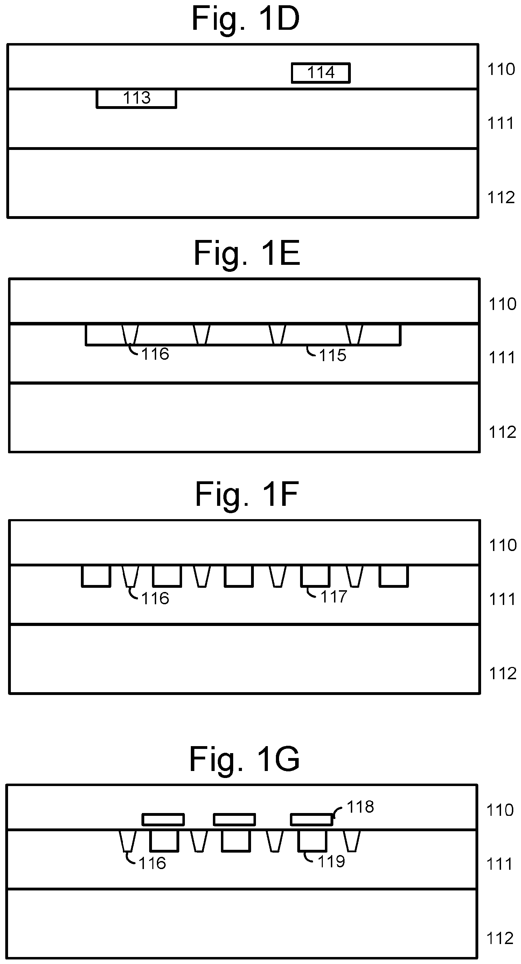

FIG. 1D depicts a cross-sectional view of a CMOS image sensor showing a photosensitive semiconductor layer 111 (e.g., an epitaxial layer or region), a photodiode 113, a photogate 114, a dielectric insulating material 110 and a substrate 112. A typical cross section in a CMOS image detector shows the photosensitive semiconductor layer that converts light radiation into electrical charges. The charges are then collected by either the photodiode or the photogate which transfers these charges into an electrical signal which is processed by in-pixel circuitry. The dielectric insulating material can comprises SiO2. The photodiode can comprise an n or p type doping to collect the electrical charges which are generated by the light. A gate electrode is configured as the photogate. The photosensitive semiconductor layer may be an epitaxial layer of the substrate. It is typically a low doped region where most of the absorbed optical radiation is useful, e.g., can be converted into charges. The substrate is typically a high doped region with faster photo carrier recombination, where most of the absorbed optical radiation is lost.

FIG. 1E depicts a cross-sectional view of a CMOS image sensor showing a photosensitive semiconductor layer 111 in which one photodiode is integrated with STI structures. FIG. 1E-1G provides different CMOS image detectors, which may or may not be time-of-flight image sensors, showing the photosensitive semiconductor layer of the CMOS image detector with integrated STI structures which have a different dielectric constant than the surrounding epitaxial layer. In FIG. IE, one photodiode 115(e.g., PN junction, PIN, pinned or buried) is integrated with the STI structures, one example of which is the STI structure 116.

FIG. 1F depicts a cross-sectional view of a CMOS image sensor showing a photosensitive semiconductor layer 111 in which different photodiodes are integrated with STI structures. Different photodiodes (e.g., PN junction, PIN, pinned or buried), one example of which is the photodiode 117, are integrated with the STI structures including the STI structure 116.

FIG. 1G depicts a cross-sectional view of a CMOS image sensor showing a photosensitive semiconductor layer 111 in which different photogates and doped regions are integrated with STI structures. Different photogates, one example of which is the photogate 118, and doped regions, one example of which is the doped region 119, are integrated with STI structures including the STI structure 116.

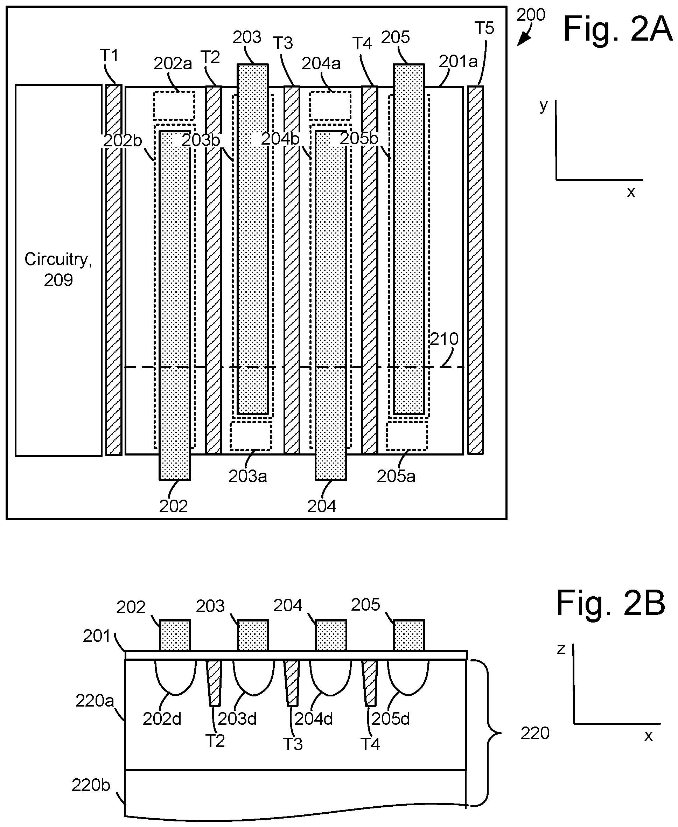

FIG. 2A depicts a top view of a pixel in an image sensor, where the pixel includes four elongated gate electrodes and shallow trench isolation (STI) structures between the gate electrodes. This example uses a photogate as a photo generated carrier collector node. Other types of collector nodes may be used as an alternative. A pixel in a time-of-flight image sensor typically includes two, four or six gate electrodes which collected charges which are generated in the substrate due to incoming light. Charges are accumulated by the gate electrodes and read out from each pixel to determine an amount of light which was detected by the pixel. In the case of four gate electrodes, each frame of data includes a period in which charge is acquired, followed by a read out period and a data processing period. This is an example of a multi-gate pixel in a time-of-flight sensor.

Here, an example pixel 200 includes an active light-detection region 201a in which charges are generated in a substrate 220 (FIG. 2B) when light is received. The substrate includes an epitaxial layer 220a and an underlying non-epitaxial or bulk portion 220b. The light-detection region may include an oxide layer 201 which is deposited over the active light-detection region. Further, elongated gate electrodes 202, 203, 204 and 205 are provided directly above respective p-type doped regions 202b, 203b, 204b and 205b, respectively, of a substrate. The charges collected by each gate electrode are routed to one of the n+ doped charge collection regions 202a, 203a, 204a and 205a from which the charges are read out. Circuitry 209 is also provided in each pixel for performing logic functions based on the read out charges of the pixel and reporting back to a sensor controller. The circuitry can provide timing or clock signals to the gate electrodes to read out charges at specified times. The pixel extends in an x-y plane of a Cartesian coordinate system, where the x-direction is a first direction and the y-direction is a second direction which is perpendicular to the first direction.

Additionally, STI structures T1, T2, T3, T4 and T5 are provided. T1 and T5 are on opposing sides of the active area, outside the active area. Also, T1 is between the circuitry and the active area to isolate these two areas from one another. Other STI structures can be provided to isolate adjacent pixels from one another. The STI structures which affect the pixel performance are T2, T3 and T4. T2 extends in the substrate between and parallel to the adjacent pair of gate electrodes 202 and 203. T3 extends in the substrate between and parallel to the adjacent pair of gate electrodes 203 and 204. T4 extends in the substrate between and parallel to the adjacent pair of gate electrodes 204 and 205. The STI structures have a uniform width along their length in the y-direction, where the width is the dimension in the x-direction in this example.

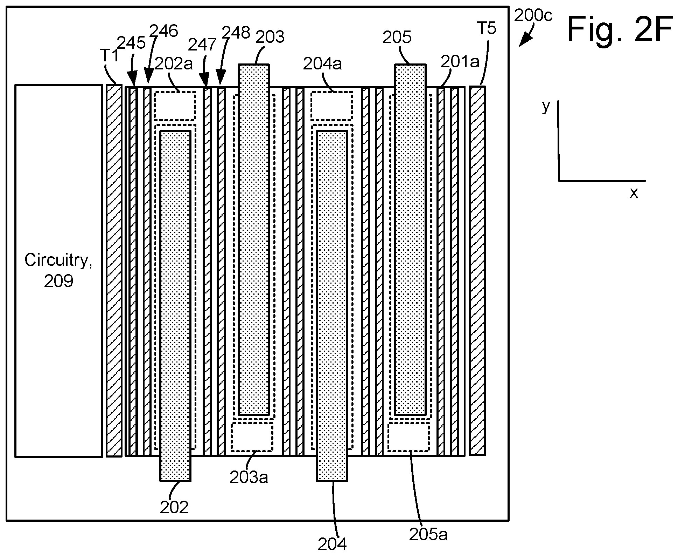

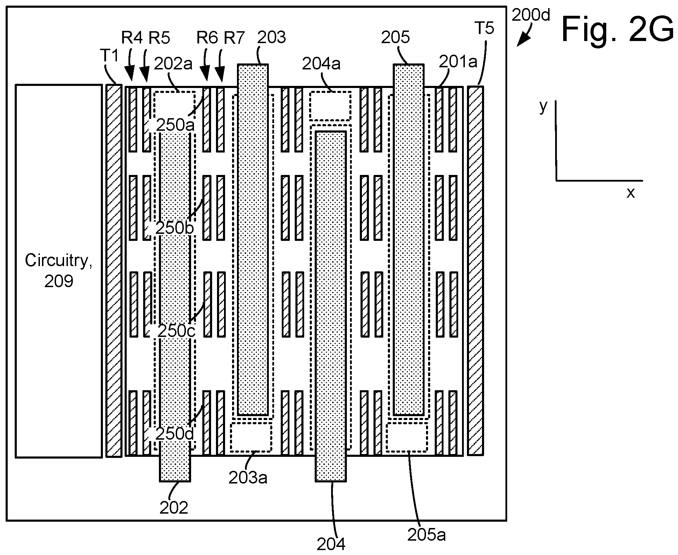

In this example, the STI structures are only between the gate electrodes. It is also possible to provide STI structures at the edges of the active light-detection region 201a, such as shown in FIG. 2F and 2G.

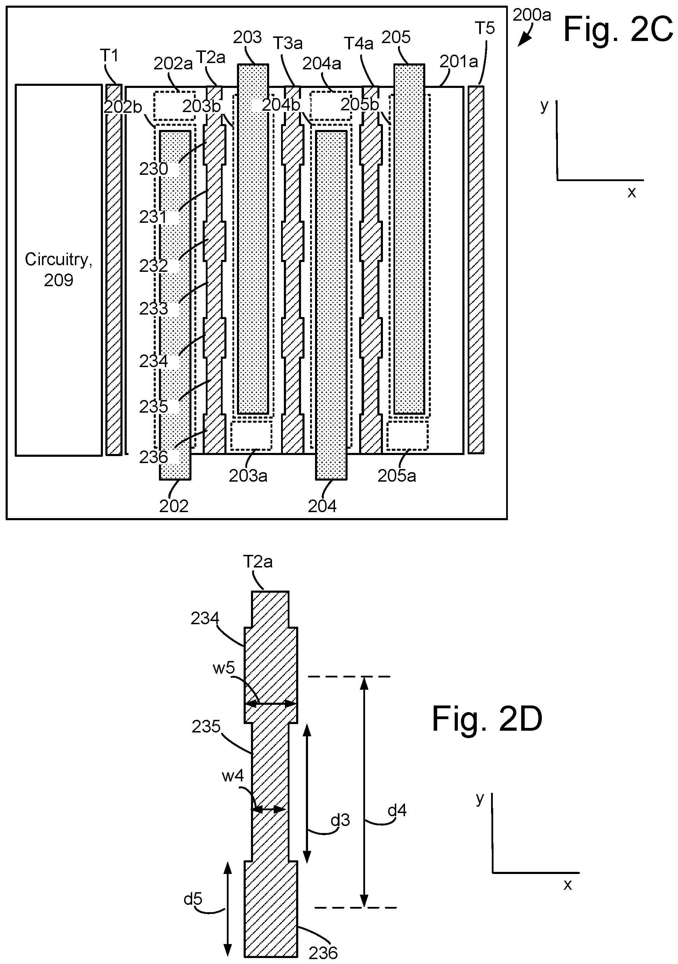

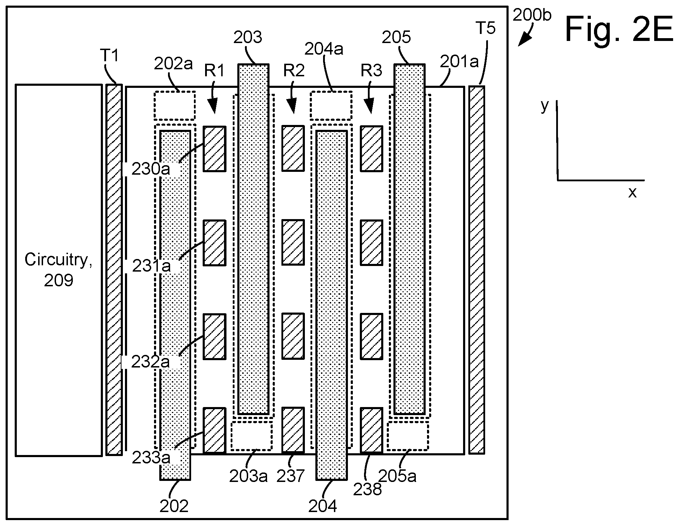

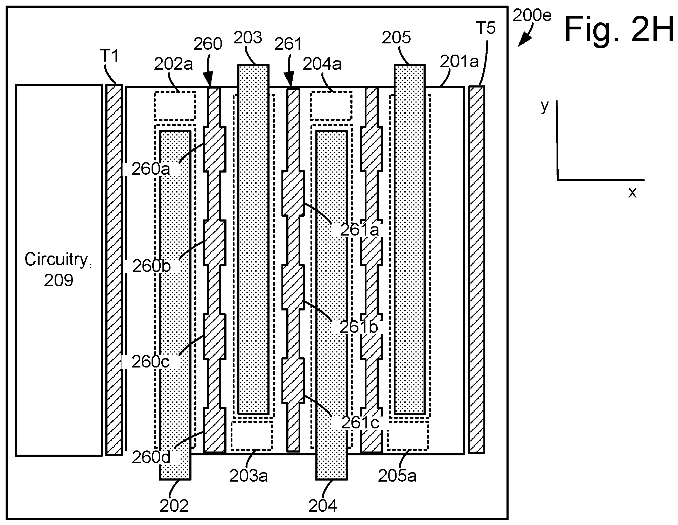

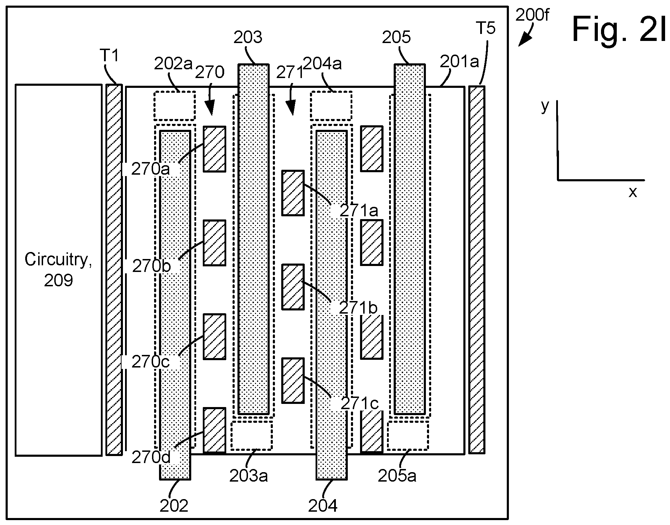

FIG. 2A, 2C and 2F provide an example of a 1-D diffraction grating, while FIG. 2E, 2G, 2H and 2I provide an example of a 2-D diffraction grating.

FIG. 2B depicts a cross-sectional view along line 210 of the pixel of FIG. 2A. The gate electrodes 202, 203, 204 and 205 are depicted above the oxide layer 201. Low p-type doping areas 202d, 203d, 204d and 205d can be provided directly under each gate electrode 202, 203, 204 and 205, respectively. The doping area 202d is an example of a first doped region, and the doping area 203d is an example of a second doped region. In one approach, the p-type dopant is provided by ion implantation. This could be done before the oxide layer is deposited, for instance. The electrodes 202 and 203 may be a first and second gate electrodes, respectively, which are charge collectors in a multi-gate pixel in a time-of-flight sensor. Further, the STI structures T2, T3 and T4 are depicted.

The epitaxial layer is configured with a doping gradient with higher doping deeper in the epitaxial layer and lower doping at a surface of the epitaxial layer for much faster charge collection.

FIG. 2C depicts a top view of a pixel 200a in an image sensor, where STI structures between the gate electrodes have a varying width. The example pixel 200a differs from the pixel 200 of FIG. 2A in that the STI structures T2a, T3a and T4a have a varying or non-uniform width in the x-direction. For instance, T2a can be a first STI structure having a periodically varying width in a second direction (y-direction). The varying width can comprise relatively wider portions and relatively narrower portions, where the relatively wider portions are spaced apart from one another by equal distances in the second direction. For example, T2a has relatively wider portions 230, 232, 234 and 236 and relatively narrower portions 231, 233 and 235. See also FIG. 2D. The varying width can provide a diffraction like effect which modifies the incoming light in a way which increases the amount of charge generated in the substrate by the incoming light.

FIG. 2D depicts an expanded view of a portion of the trench T2a of FIG. 2C. The relatively wider portions 234 and 236 have a width of w5 in the x-direction. Their midpoints are spaced apart by a distance d4, their closest points are spaced apart by a distance d3 and they have a length of d5 in the y-direction. The relatively narrower portion 235 has a width of w4<w5 and the length d3 in the y-direction.

FIG. 2E depicts another example of a pixel 200b, where STI structures are spaced apart from one another in an x-direction and a y-direction to form a 2D diffraction grating. An example row R1 includes STI structures 230a, 231a, 232a and 233a. Rows R2 (with example STI structure 237) and R3 (with example STI structure 238) are also depicted. In this example, the rows of STI structures are uniform, such that corresponding STI structures are positioned at the same positions in the y-direction.

FIG. 2F depicts another example of a pixel 200c, where STI structures are spaced apart from one another in an x-direction to form a 1-D diffraction grating, and two STI structures are provided between adjacent gate electrodes. In this example, STI structures 245 and 246 extend the length of the gate electrode 202 and are between the gate electrode 202 and the trench T1. STI structures 247 and 248 extend the length of the gate electrode 202 and are between the gate electrodes 202 and 203. The use of multiple trenches as shown can provide a higher periodicity to a diffraction grating.

FIG. 2G depicts another example of a pixel 200d, where STI structures are spaced apart from one another in an x-direction and a y-direction to form a 2-D diffraction grating, and two rows of STI structures are provided between adjacent gate electrodes. Example rows R4, R5, R6 and R7 include multiple STI structures. For example, R6 includes STI structures 250a, 250b, 250c and 250d. In this example, each row is uniform. FIG. 2F and 2G provide an example where an integrated shallow trench isolation structure is among a plurality of shallow trench isolation structures which are positioned between adjacent photodiode structures or photogate structures in the substrate.

FIG. 2H depicts another example of a pixel 200e, where STI structures are spaced apart from one another in an x-direction and have a varying width in a y-direction to form a 2-D diffraction grating, and different rows of the STI structures are non-uniform. An example STI structure 260 includes four widened regions 260a, 260b, 260c and 260d, while an example STI structure 261 includes three widened regions 261a, 261b and 261c. In this example, the STI structures 260 and 261 are non-uniform. Each structure includes a different number of widened regions, and the widened regions of the adjacent structures 260 and 261 are offset in the y-direction.

FIG. 2I depicts another example of a pixel 200f, where STI structures are spaced apart from one another in an x-direction and a y-direction to form a 2-D diffraction grating, and different rows of the STI structures are non-uniform. Example rows 270 and 271 include multiple STI structures. For example, row 270 includes four STI structures 270a, 270b, 270c and 270d, and row 271 includes three STI structures 271a, 271b and 271c. In this example, the rows are non-uniform. For example, adjacent rows 270 and 271 include different numbers of STI structures, and the STI structures are offset or staggered in the y-direction.

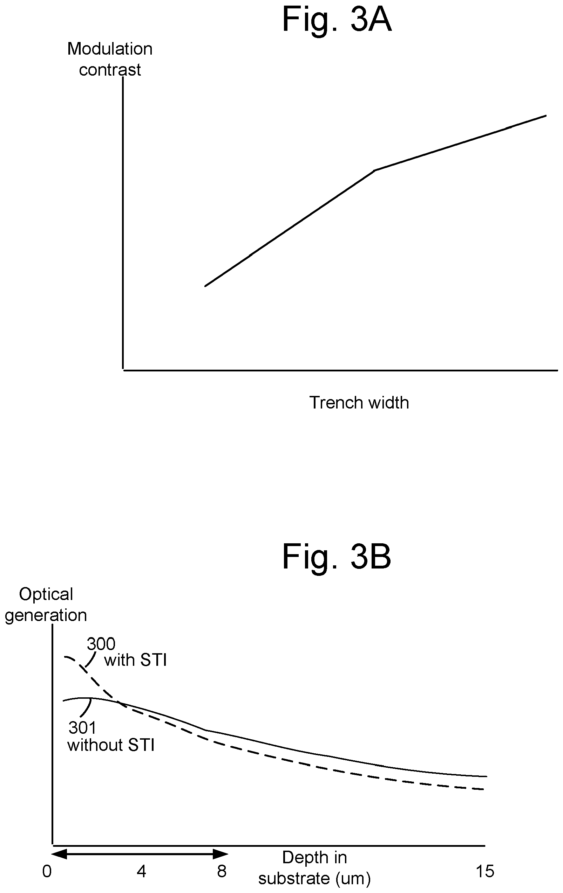

FIG. 3A depicts a plot of modulation contrast versus trench width for the pixel of FIG. 2A and 2B. As mentioned, the modulation constant is a measure of how well higher high intensity light can be distinguished from low intensity light. The modulation contrast is higher with increasing trench width. Generally, a wider trench is desirable, but there is a practical limit. For example, the trench should not extend directly under a gate electrode as this will interfere with the functioning of the gate electrode. The distance between the gate electrodes might be 1-2 µm, in which case the trench width could be about 0.3-0.7 µm without affecting the gate electrode or the doped region below the gate electrode. A gap is typically maintained in the substrate between the gate electrode and the trench.

Generally, a modulation contrast of the pixel varies with a size, e.g., width and/or a depth (or other dimension) of the integrated shallow trench isolation structure, and the width or other dimension can be optimized for a highest modulation contrast.

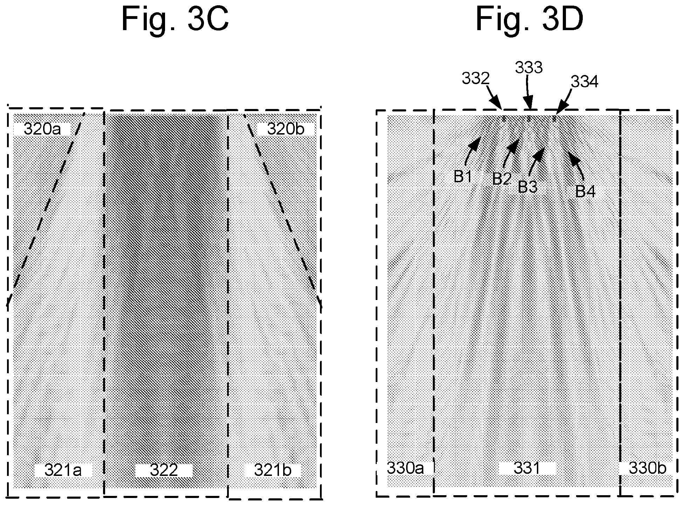

FIG. 3B depicts a plot of optical generation versus depth in substrate (plot 300), for the pixel of FIG. 2A and 2B and a comparable pixel which does not have the STI structures (plot 301). Generally, most of the optical generation occurs near the top surface of the substrate such as in an 8 µm thick region. With the use of STI structures, there is additional absorption and optical generation at the first four or five microns. A high concentration of charges close to the surface is desirable because it is close to the gate electrode which collects the charges. The STI structures redistribute the energy of the light so there is more optical generation near the substrate surface. See also FIG. 3C and 3D. The optical generation is about the same in a remainder of the substrate, down to about 15 µm from the surface of the substrate.

FIG. 3C depicts optical generation in the substrate for a comparable pixel which does not have the STI structures, with a substrate depth on the vertical axis and a horizontal (x-axis) dimension along the horizontal axis. The data depicted is for a time-of-flight or other image sensor which detects infrared light at 850 nm. A central region 322 has a relatively high and uniform optical generation. Lateral regions 321a and 321b have a moderate optical generation and lateral regions 320a and 320b have a low optical generation. In FIG. 3C and 3D, the top of the figure represents the top surface of the substrate. The redistribution of the optical energy is believed to be stronger closer to the STI structures.

FIG. 3D depicts optical generation in the substrate of the pixel of FIG. 2A and 2B, with a substrate depth on the vertical axis and a horizontal (x-axis) dimension along the horizontal axis. The image sensor detects infrared light at 850 nm. STI structures 332, 333 and 334 (corresponding to STI structures T2, T3 and T4, respectively) are depicted at a top of the substrate, e.g., in an example pixel similar to FIG. 2A. A central region 331 has a relatively high and non-uniform optical generation. In particular, well-defined beams B1, B2, B3 and B4 of highest intensity are provided due to the diffraction grating effect provided by the multiple STI structures in the pixel. A diffraction grating is an optical component with a periodic structure, which splits and diffracts light into several beams travelling in different directions. Lateral regions 330a and 330b have a moderate optical generation.

As depicted, the height of the STI structures is much smaller than a height of a region of the substrate in which light is received and charges are generated.

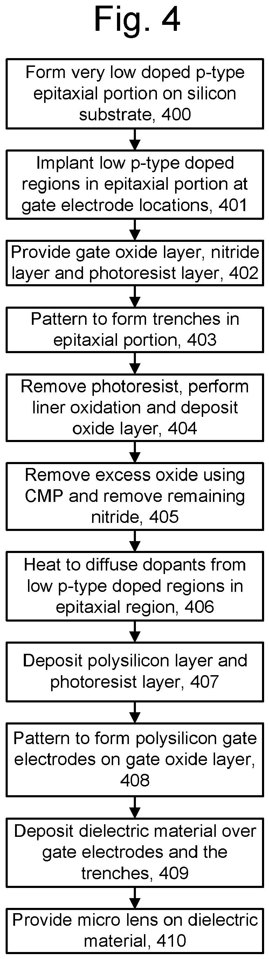

FIG. 4 depicts a process for fabricating an image sensor which includes the pixel of FIG. 2A. Other example processes are possible as well. Step 400 includes forming a very low doped p-type epitaxial layer on a silicon substrate, such as depicted in FIG. 2B. In one approach, the underlying portion is heavily doped p-type, with a dopant concentration of about 1-5^{∗}10^18/cm3 and is on the order of several hundred µm thick. An example thickness of the epitaxial layer is about 20 µm with a dopant concentration of between about 10^16 and Sx10^17/cm3. This epitaxial layer is almost intrinsic.

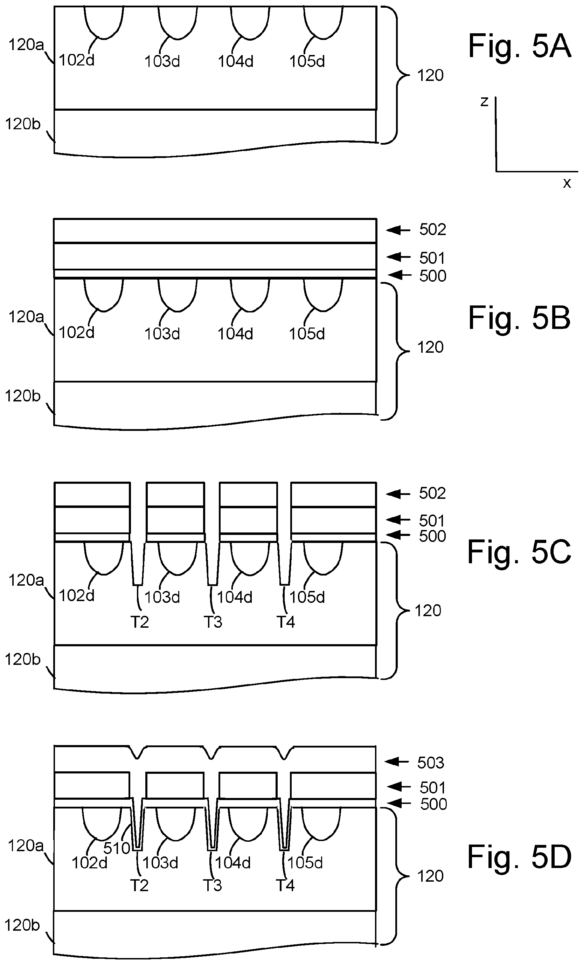

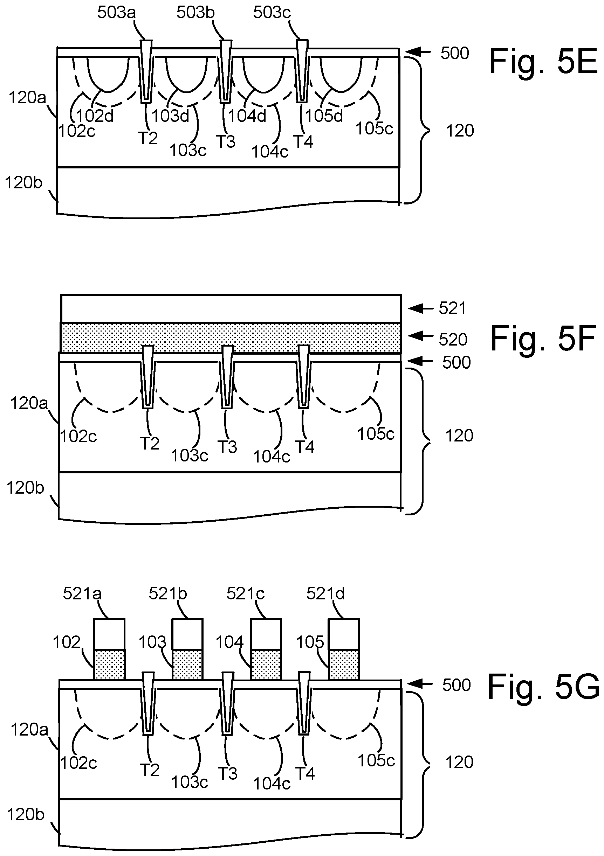

Step 401 includes implanting low p-type doped regions in the epitaxial layer at gate electrode locations. See also FIG. 5A. An example doping concentration is _5x10^14/cm3. An example dopant is Boron. These low p-type doped regions are regions in which charge collection occurs when a positive voltage is applied to a gate electrode. Step 402 includes providing a thin gate oxide layer, e.g., SiO2, with an example thickness of 50 Angstroms, a nitride layer and a photoresist layer on the substrate. See also FIG. 5B. For example, the gate oxide layer may be deposited using chemical vapor deposition (CVD) or grown on the epitaxial layer by exposing the region to oxygen. Step 403 include performing patterning to form trenches in the epitaxial layer. See also FIG. 5C. Step 404 includes removing the photoresist, performing liner oxidation and depositing an oxide layer to fill the trenches. The liner oxidation involves growing a thermal oxide in the trench and stopping after the formation of a thin oxide liner. See also FIG. 5D. Step 405 involves removing the excess oxide, e.g., using chemical-mechanical polishing (CMP) and removing the remaining nitride. See also FIG. 5E. Step 406 involves heating, e.g., annealing, the substrate to cause dopants to diffuse outward from the low p-type doped regions toward the trenches to passivate the walls of the trenches. See also FIG. 5E. Generally, the dopants diffuse to an extent which is sufficient to passivate a majority of the walls of the trenches. The heating could alternatively occur at a later point in the fabrication. This step indicates that a dopant within the photosensitive semiconductor layer is configured to passivate sidewalls of the integrated shallow trench isolation structure, resulting in a low dark current pixel.

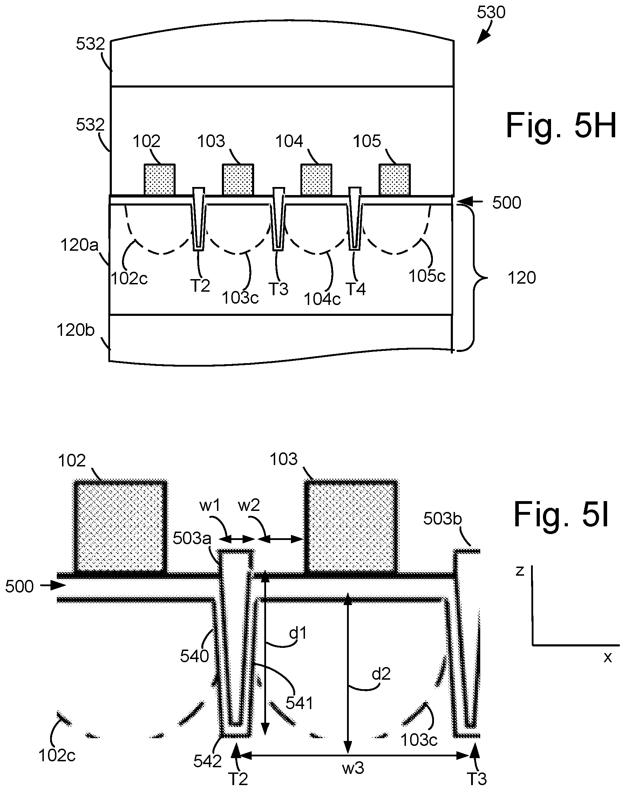

Step 407 involves depositing a polysilicon gate layer (which may be doped n type) and a photoresist layer. See also FIG. 5F. Step 408 involves patterning to form polysilicon gate electrodes on the gate oxide layer. See also FIG. 5G. Step 409 involves depositing a dielectric material over the gate electrodes and the trenches, as well as over portions of the gate oxide layer. See also FIG. 5H. For example, the dielectric material may also be SiO2, but is thicker than the gate oxide layer. In another example, dielectric material is a nitride. The gate oxide and the dielectric material are typically undoped. Step 410 includes providing a micro lens on the dielectric material. See also FIG. 5H.

The steps provided are an example only, as other implementations are possible.

A more general method of fabricating a CMOS image sensor with improved optical sensitivity comprises: providing an oxide layer on a top surface of an epitaxial portion of a substrate; providing a shallow trench isolation structure which acts as an optical grating at an interface layer between the oxide layer and the substrate; providing single or multiple photodiode structures or photogate structures; and providing a dielectric material over the multiple photodiode structures or photogate structures and the oxide layer.

In this method, the shallow trench isolation structure is positioned within a single photodiode structure or is among a plurality of shallow trench isolation structures which are positioned alternatingly with the photodiode structures or photogate structures in the substrate.

The shallow trench isolation may act as the optical grating to at least one of diffract, deflect or reflect incident light at the interface layer and redistribute the incident light within the epitaxial portion of the substrate of the sensor.

The method may further include implanting dopants to form doped regions in the epitaxial portion of the substrate; and heating the substrate to cause the dopants of the doped regions to diffuse laterally in the epitaxial portion of the substrate of the shallow trench isolation structure.

A more general method of fabricating a CMOS time-of-flight image sensor with improved modulation contrast comprises: providing an oxide layer on a top surface of an epitaxial portion of a substrate; providing multiple photodiode structures or photogate structures; providing a shallow trench isolation structure which acts as a physical barrier to electrical charges motions between the photodiode structure or photogate structures; and providing a dielectric material over the photodiode structures or photogate structures and the oxide layer.

In an example implementation, the integrated shallow trench isolation structure is among a plurality of shallow trench isolation structures which are positioned alternatingly with the photodiode structures or photogate structures in the substrate.

In another example implementation, the integrated shallow trench isolation structure is among a plurality of shallow trench isolation structures which are positioned between adjacent photodiode structures or photogate structures in the substrate.

FIG. 5A depicts a cross-sectional view of a pixel according to step 401 of FIG. 4. The low p-type doping areas 102d, 103d, 104d and 105d can be provided directly under a location of each gate electrode 102, 103, 104 and 105, respectively. A substrate 120 includes an epitaxial layer 120a and a non-epitaxial layer 120b.

FIG. 5B depicts a cross-sectional view of a pixel according to step 402 of FIG. 4. A gate oxide layer 500 is provided, followed by a nitride layer 501 and a photoresist layer 502.

FIG. 5C depicts a cross-sectional view of a pixel according to step 403 of FIG. 4. The photoresist layer is patterned according to a mask to create openings in the photoresist layer which are aligned with locations in the substrate in which the trenches are to be etched. Subsequently, in one possible approach, the nitride layer, the gate oxide layer and the substrate are etched through the openings, resulting in the trenches T2, T3 and T4.

FIG. 5D depicts a cross-sectional view of a pixel according to step 404 of FIG. 4. An oxide liner is grown in the trenches, such as oxide liner 510 in T2. Subsequently, oxide 503 is deposited, over-filling the trenches so that excess oxide is deposited on the nitride layer portions.

FIG. 5E depicts a cross-sectional view of a pixel according to steps 405 and 406 of FIG. 4. The excess oxide is removed, then the remaining nitride is removed, exposing the gate oxide layer 500 and the deposited oxide 503a, 503b and 503c in the trenches T2, T3 and T4, respectively. A portion of the deposited oxide may extend above the top surface of the substrate as shown. Additionally, the heating step cause the dopants to diffuse in the substrate so that a portion of the dopants reach the walls of the trenches, including the sidewalls and perhaps the bottom wall. The heating also activate the dopants. The low p-type doping areas 102d, 103d, 104d and 105d expand to become doping areas 102c, 103c, 104c and 105c, respectively.

FIG. 5F depicts a cross-sectional view of a pixel according to step 407 of FIG. 4. The polysilicon gate layer 520 and a photoresist layer 521 are depicted.

FIG. 5G depicts a cross-sectional view of a pixel according to step 408 of FIG. 4. The photoresist layer is patterned according to a mask to create openings in the photoresist layer which are aligned with portions of the gate electrode layer which are to be removed. Subsequently, the gate electrode layer is etched through the openings, resulting in the gate electrodes 102, 103, 104 and 105. The remaining portions 521a, 521b, 521c and 521d of the photoresist layer are then removed.

FIG. 5H depicts a cross-sectional view of a pixel 530 according to step 409 and 410 of FIG. 4. A dielectric material 531 is deposited to cover the gate electrodes and trenches, and a micro lens 532 is provided on the dielectric layer.

FIG. 5I depicts an expanded view of a portion of the pixel of FIG. 5H. The example trench T2 has side walls 540 (one sidewall) and 541 (another sidewall) and a bottom wall 542. A height of the trench, from the surface of the substrate to the bottom wall, is d1. A height of the doping region 103c, from the surface of the substrate to the bottom of the doping region, is d2, which can be larger or smaller than d1. A width of the trench at its top is w1. A distance w2 separate the top of the trench from the gate electrode 103. A distance w3 is a distance in the x-direction between the midpoints of the adjacent trenches T2 and T3. Note that the figures are not necessarily to scale.

Referring to FIG. 2C and 5I, this is an example of a plurality of shallow trench isolation structures (T2-T4) which are spaced apart from one another by a first distance (w3) in a first direction (x-direction) of the silicon substrate, where each STI structure of the plurality of STI structures has a varying width (w4, w5) in a second direction (y-direction) which is perpendicular to the first direction. Further, the varying width comprises relatively wider portions (230, 232, 234, 236) and relatively narrower portions (231, 233, 235), and the relatively wider portions are spaced apart from one another by a second distance (d3 or d4) in the second direction.

This is also an example of a first STI structure (T2) which is among a plurality of inter-gate electrode STI structures (T2-T4) of the pixel, where the plurality of inter-gate electrode STI structures are in the epitaxial layer of the substrate and are spaced apart from one another by equal amounts (w3) in a first direction.

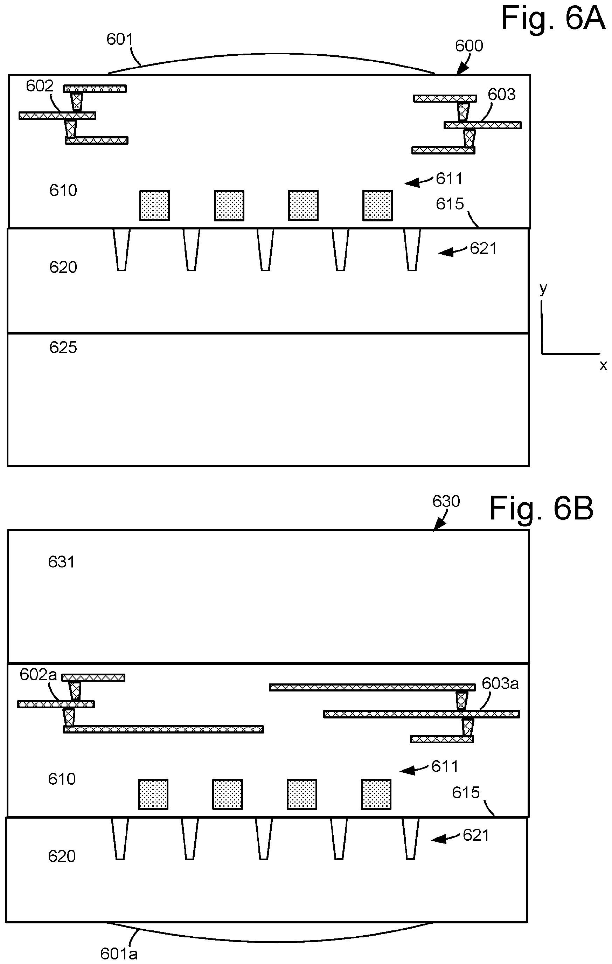

FIG. 6A depicts an example pixel in which STI structures are on a side of the epitaxial layer which faces the micro lens, in a front side illumination design. The pixel 600 comprises a micro lens 601, a dielectric insulating material 610, including metal interconnections 602 and 603 and gate electrodes 611, STI structures 621 on a side 615 of an epitaxial layer 620 which faces the micro lens, and a non-epitaxial substrate 625. In the front side illumination case, the STI structures diffract and deflect the incident light in a transmission mode.

FIG. 6B depicts an example pixel in which STI structures are on a side of the epitaxial layer which faces away from the micro lens, in one example of a back side illumination design. The pixel 630 comprises a micro lens 601a, the dielectric insulating material 610, including metal interconnections 602a and 603a and the gate electrodes 611, the STI structures 621 on a side 615 of the epitaxial layer 620 which faces away from the micro lens, and a substrate carrier wafer 631 which supports the pixel. In the back side illumination case, the STI structures diffract and deflect the incident light in a reflection mode. Moreover, the metal interconnections 602a and 603a may extend behind the epitaxial layer 620 without blocking incident light. In both the front side and back side cases, the optical light energy is redistributed within the epitaxial layer and more optical generation is observed. A greater improvement may be seen with the back side case than the front side case because more incident light can reach the photosensitive semiconductor layer due to the absence of the metal interconnections between the micro lens and the epitaxial layer.

To form the back side device, the original substrate (such as substrate 625 in FIG. 6A) with the epitaxial layer comprising the STI structures and the dielectric layer is may be attached at the dielectric layer to the substrate carrier wafer 631. The original substrate can then be removed by grinding followed by a wet etch, in a thinning process.

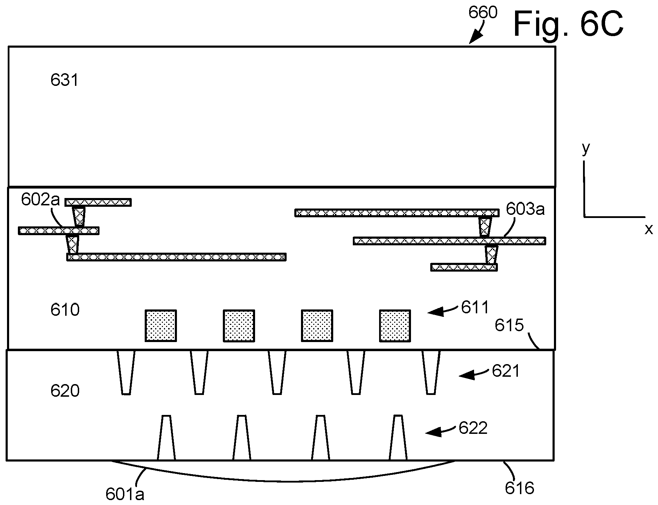

FIG. 6C depicts an example pixel in which STI structures 621 are on a side 615 of the epitaxial layer which faces away from the micro lens, and additional STI structures 622 are on an opposing side 616 of the epitaxial layer which faces the micro lens 601a, in another example of a back side illumination design. The additional STI structures 622 can help redistribute the optical light energy within the epitaxial layer 620.

This is an example of a pixel 660 which is configured in a backside illumination condition with an integrated micro lens 601a, where the integrated shallow trench isolation structure is among a plurality of integrated shallow trench isolation structures 621 which are provided on one side 615 of the epitaxial layer 620 which faces away from the micro lens, an additional integrated shallow trench isolation structure is among a plurality of integrated shallow trench isolation structures 622 which are provided on an opposing side 616 of the epitaxial layer which faces the micro lens, and the additional integrated shallow trench isolation structure is fabricated using a CMOS process to improve the pixel optical sensitivity. This approach is advantageous because the STI structures 621 diffract and deflect the incident light in a reflection mode while the STI structures 622 diffract and deflect the incident light in a transmission mode.

Generally, the epitaxial layer 620 may include the STI structures 621 but not the STI structures 622, the STI structures 622 but not the STI structures 621, or both the STI structures 621 and 622.

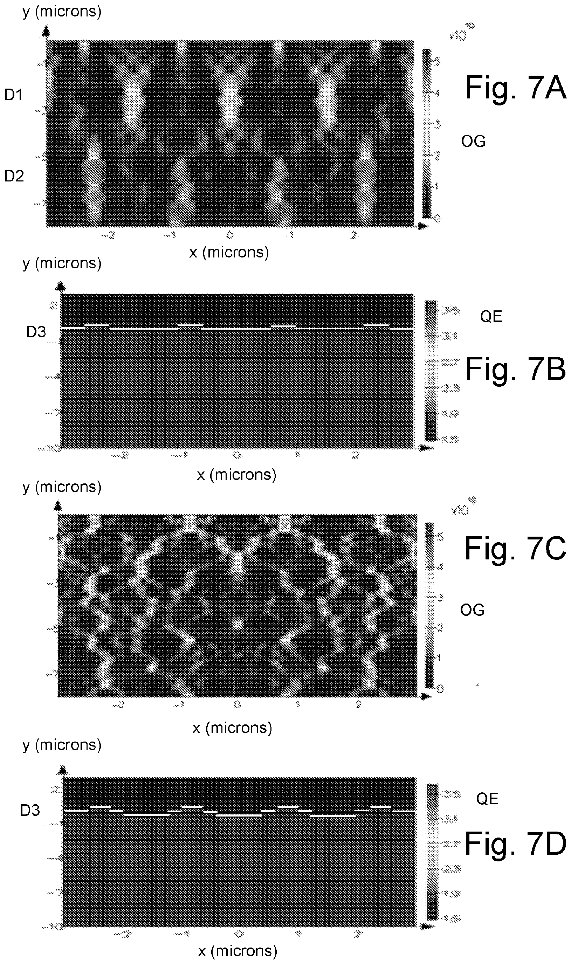

FIG. 7A depicts a plot of the redistribution of optical generation (OG) or absorption in the epitaxial layer by adding the STI structure in an example front side illumination design. The results are from a numerical optical simulation. In FIG. 7A and 7C, the horizontal axis depicts a dimension in the x-direction, e.g., laterally in the epitaxial layer, the vertical axis depicts a depth in the epitaxial layer and the shading depicts the OG. Regions of relatively high OG are located periodically in the x-direction at a first depth D1 and a second, lower depth D2. The regions are narrow in the x-direction and relatively long in the y-direction. OG refers to an amount of electrical energy which is obtained from an amount of optical energy.

FIG. 7B depicts a plot of an improvement in quantum efficiency (QE) due to the STI structure, consistent with FIG. 7A. In FIG. 7B and 7D, the horizontal axis depicts a dimension in the x-direction the vertical axis depicts a depth in the epitaxial layer and the shading depicts the QE. A relatively higher QE is observed below a certain depth D3 than above it.

FIG. 7C depicts a plot of the redistribution of optical generation in the epitaxial layer by adding the STI structure in another example front side illumination design. The regions of relatively high OG extend generally diagonally and vertically in the epitaxial layer.

FIG. 7D depicts a plot of an improvement in quantum efficiency due to the STI structure, consistent with FIG. 7C. A relatively higher QE is observed below the depth D3 than above it.

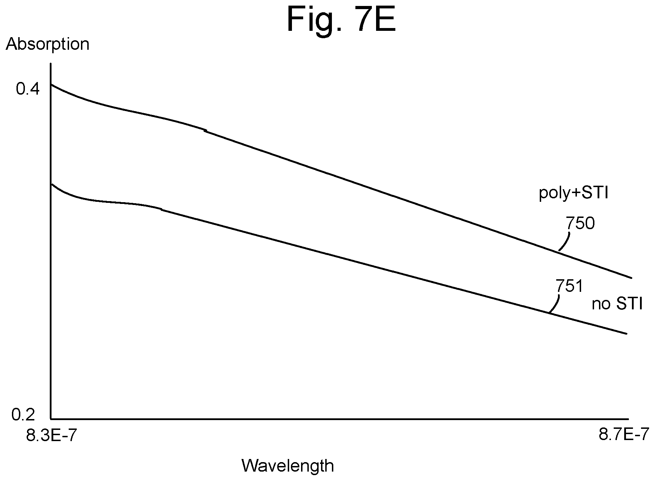

FIG. 7E depicts a plot of absorption on the vertical axis versus wavelength on the horizontal axis, showing an increase in absorption due to the STI structure. Plot 750 represents the case of a pixel with polysilicon gate electrodes and STI structures. Plot 751 represents the case of a pixel with polysilicon gate electrodes and no STI structure. A significant increase in absorption can be observed.

Accordingly, it can be seen that, in one approach, a CMOS image sensor (e.g., a pixel) comprises: a photosensitive semiconductor layer comprising an epitaxial layer, the epitaxial layer comprising one or more photodiodes or photogates to convert incident light into electrical charges; one or more pixel charge collector nodes configured to collect the electrical charges; and an integrated shallow trench isolation structure configured to modify the incident light at an interface of the photosensitive semiconductor layer by at least one of diffraction, deflection or reflection, to redistribute the incident light within the photosensitive semiconductor layer to improve an optical sensitivity of a pixel.

The integrated shallow trench isolation structure comprises a dielectric material having a first dielectric constant; the photosensitive semiconductor layer, which surrounds the integrated shallow trench isolation structure, has a second dielectric constant which is different than the first dielectric constant; and the integrated shallow trench isolation structure and the photosensitive semiconductor layer provide an optical grating.

The integrated shallow trench isolation structure and the photosensitive semiconductor layer provide an optical grating; and the optical grating may be configured to at least one of diffract, deflect or reflect the incident light at its interface layer.

A dopant within the photosensitive semiconductor layer may be configured to passivate sidewalls of the integrated shallow trench isolation structure, resulting in a low dark current pixel.

The integrated shallow trench isolation structure may be among a plurality of integrated shallow trench isolation structures which are fabricated in a CMOS process and are configured in a one-dimensional or two-dimensional optical grating to redistribute the incident light within the photosensitive semiconductor layer.

The integrated shallow trench isolation structure may be among a plurality of integrated shallow trench isolation structures are arranged in uniform or non-uniform rows.

The pixel may be configured in either a front side illumination condition or a backside illumination condition with or without an integrated micro lens.

The pixel may be configured in a backside illumination condition with an integrated micro lens; the integrated shallow trench isolation structure may be among a plurality of integrated shallow trench isolation structures which are provided on one side of the epitaxial layer which faces away from the integrated micro lens; and an additional integrated shallow trench isolation structure is among a plurality of integrated shallow trench isolation structures which are provided on an opposing side of the epitaxial layer which faces the integrated micro lens.

The pixel may be configured in a backside illumination condition with an integrated micro lens; and the integrated shallow trench isolation structure may be among a plurality of integrated shallow trench isolation structures which are provided on a side of the epitaxial layer which faces away from the integrated micro lens.

The pixel may be configured in a backside illumination condition with an integrated micro lens; and the integrated shallow trench isolation structure may be among a plurality of integrated shallow trench isolation structures which are provided on a side of the epitaxial layer which faces the integrated micro lens.

The epitaxial layer may be configured with a doping gradient with higher doping deeper in the epitaxial layer and lower doping at a surface of the epitaxial layer for much faster charge collection.

The pixel may be configured to be used in a time-of-flight sensor; and the integrated shallow trench isolation structure may be configured as a physical barrier to movement of electrical charges between different photogates or photodiodes in the pixel, resulting in a higher modulation contrast.

The pixel may be configured to be used in a time-of-flight sensor; where a modulation contrast of the pixel varies with a size (width and/or a depth) of the integrated shallow trench isolation structure, and the size is optimized for a highest modulation contrast.

In another approach, a method of fabricating a CMOS image sensor with improved optical sensitivity, comprises: providing an oxide layer on a top surface of an epitaxial portion of a substrate; providing a shallow trench isolation structure which acts as an optical grating at an interface layer between the oxide layer and the substrate; providing single or multiple photodiode structures or photogate structures; and providing a dielectric material over the multiple photodiode structures or photogate structures and the oxide layer.

The shallow trench isolation structure may be positioned within a single photodiode structure or may be among a plurality of shallow trench isolation structures which are positioned alternatingly with the photodiode structures or photogate structures in the substrate.

The method may further include implanting dopants to form doped regions in the epitaxial portion of the substrate; and heating the substrate to cause the dopants of the doped regions to diffuse laterally in the epitaxial portion of the substrate of the shallow trench isolation structure.

The shallow trench isolation structure may be among a plurality of shallow trench isolation structures which are positioned between adjacent photodiode structures or photogate structures in the substrate.

In another approach, means for fabricating a CMOS image sensor with improved optical sensitivity comprise: means for providing an oxide layer on a top surface of an epitaxial portion of a substrate; providing a shallow trench isolation structure which acts as an optical grating at an interface layer between the oxide layer and the substrate; means for providing single or multiple photodiode structures or photogate structures; and means for providing a dielectric material over the multiple photodiode structures or photogate structures and the oxide layer.

## Claims

1. A CMOS image sensor, comprising:
a photosensitive semiconductor layer (111) comprising an epitaxial layer (220a, 120a, 620), the epitaxial layer (220a, 120a, 620) comprising a plurality of photodiodes (113, 115, 117) or photo gates (114) to convert incident light into electrical charges; and
an integrated shallow trench isolation structure (T2-T4, 621, 622, 116) disposed in the epitaxial layer (220a, 120a, 620) and between photodiodes (113, 115, 117) or photogates (114), wherein:
the integrated shallow trench isolation structure (T2-T4, 621, 622, 116) comprises a dielectric material (510) having a first dielectric constant;
the photosensitive semiconductor layer (111), which surrounds the integrated shallow trench isolation structure (T2-T4, 621, 622, 116), has a second dielectric constant which is different than the first dielectric constant;
the integrated shallow trench isolation structure (T2-T4, 621, 622, 116) and the photosensitive semiconductor layer (111) provide an optical grating; and
the optical grating is configured to at least one of diffract, deflect or reflect the incident light at the interface between the integrated shallow trench isolation structure (T2-T4, 621, 622, 116) and the photosensitive semiconductor layer (111) and to redistribute the incident light within the photosensitive semiconductor layer (111) to improve an optical sensitivity of a pixel,
wherein the CMOS image sensor further comprises a dopant (102c, 103c, 104c, 105c) within the photosensitive semiconductor layer (111) adjacent to the walls (540) of the integrated shallow trench isolation structure (T2-T4, 621, 622, 116) which is configured to passivate sidewalls (540) of the integrated shallow trench isolation structure (T2-T4, 621, 622, 116), resulting in a low dark current pixel.

2. The CMOS image sensor of claim 1, wherein:
the integrated shallow trench isolation structure (T2-T4, 621, 622, 116) is among a plurality of integrated shallow trench isolation structures (T2-T4, 621, 622, 116) which are fabricated in a CMOS process and are configured in a one-dimensional or two-dimensional optical grating to redistribute the incident light within the photosensitive semiconductor layer (111).

3. The CMOS image sensor of claim 1 or 2, wherein:
the integrated shallow trench isolation structure (T2-T4, 621, 622, 116) is among a plurality of integrated shallow trench isolation structures (T2-T4, 621, 622, 116) which are arranged in uniform rows (T2-T4).

4. The CMOS image sensor of claim 1 or 2, wherein:
the integrated shallow trench isolation structure (T2-T4, 621, 622, 116) is among a plurality of integrated shallow trench isolation structures (T2-T4, 621, 622, 116) which are arranged in non-uniform rows (R1-R7).

5. The CMOS image sensor of any one of claims 1 to 4, wherein:
the pixel is configured in either a front side illumination condition or a backside illumination condition with or without an integrated micro lens (601, 601a).

6. The CMOS image sensor of any one of claims 1 to 5, wherein:
the pixel is configured in a backside illumination condition with an integrated micro lens (601a);
the integrated shallow trench isolation structure (621) is among a plurality of integrated shallow trench isolation structures (621) which are provided on one side (615) of the epitaxial layer (620) which faces away from the integrated micro lens (601a); and
an additional integrated shallow trench isolation structure (622) is among a plurality of integrated shallow trench isolation structures (622) which are provided on an opposing side (616) of the epitaxial layer (620) which faces the integrated micro lens (601a).

7. The CMOS image sensor of any one of claims 1 to 6, wherein:
the pixel is configured in a backside illumination condition with an integrated micro lens (601a); and
the integrated shallow trench isolation structure (621) is among a plurality of integrated shallow trench isolation structures (621) which are provided on a side (615) of the epitaxial layer (620) which faces away from the integrated micro lens (601a).

8. The CMOS image sensor of any one of claims 1 to 6, wherein:
the pixel is configured in a backside illumination condition with an integrated micro lens (601a); and
the integrated shallow trench isolation structure (622) is among a plurality of integrated shallow trench isolation structures (622) which are provided on a side (616) of the epitaxial layer (620) which faces the integrated micro lens (601a).

9. The CMOS image sensor of any one of claims 1 to 8, wherein:
the epitaxial layer (220a, 120a, 620) is configured with a doping gradient with higher doping deeper in the epitaxial layer and lower doping at a surface of the epitaxial layer for much faster charge collection.

10. A method of fabricating a CMOS image sensor with improved optical sensitivity, the method comprising:
providing a photosensitive semiconductor layer (111) comprising an epitaxial layer (220a, 120a, 620), the epitaxial layer (220a, 120a, 620) comprising a plurality of photodiodes (113, 115, 117) or photogates (114) to convert incident light into electrical charges; and
providing an integrated shallow trench isolation structure (T2-T4, 621, 622, 116) disposed in the epitaxial layer (220a, 120a, 620) and between photodiodes (113, 115, 117) or photogates (114), wherein:
the integrated shallow trench isolation structure (T2-T4, 621, 622, 116) comprises a dielectric material (510) having a first dielectric constant;
the photosensitive semiconductor layer (111), which surrounds the integrated shallow trench isolation structure (T2-T4, 621, 622, 116), has a second dielectric constant which is different than the first dielectric constant;
the integrated shallow trench isolation structure (T2-T4, 621, 622, 116) and the photosensitive semiconductor layer (111) provide an optical grating; and
the optical grating is configured to at least one of diffract, deflect or reflect the incident light at the interface between the integrated shallow trench isolation structure (T2-T4, 621, 622, 116) and the photosensitive semiconductor layer (111) and to redistribute the incident light within the photosensitive semiconductor layer (111) to improve an optical sensitivity of a pixel,
wherein the CMOS image sensor further comprises a dopant (102c, 103c, 104c, 105c) within the photosensitive semiconductor layer (111) adjacent to the walls (540) of the integrated shallow trench isolation structure (T2-T4, 621, 622, 116) which is configured to passivate sidewalls (540) of the integrated shallow trench isolation structure (T2-T4, 621, 622, 116), resulting in a low dark current pixel.

11. The method of claim 10, wherein:
the shallow trench isolation structure (T2-T4, 621, 622, 116) is positioned within a single photodiode structure (115) or is among a plurality of shallow trench isolation structures (T2-T4, 621, 622, 116) which are positioned alternatingly with the photodiode structures (117) or photogate structures (114) in the substrate (220, 120).

12. The method of claim 10 or 11, further comprising:
implanting (401) dopants to form doped regions (102d-105d) in the epitaxial portion (220a, 120a) of the substrate (220, 120); and
heating (406) the substrate (220, 120) to cause the dopants of the doped regions (102d-105d) to diffuse laterally in the epitaxial portion (220a, 120a) of the substrate (220, 120) of the shallow trench isolation structure (T2-T4, 621, 622, 116).

## Patentansprüche

1. CMOS-Bildsensor, umfassend:
eine lichtempfindliche Halbleiterschicht (111), die eine Epitaxialschicht (220a, 120a, 620) umfasst, wobei die Epitaxialschicht (220a, 120a, 620) eine Vielzahl von Fotodioden (113, 115, 117) oder Fotogates (114) umfasst, um einfallendes Licht in elektrische Ladungen umzuwandeln; und
eine integrierte flache Grabenisolationsstruktur (T2-T4, 621, 622, 116), die in der Epitaxialschicht (220a, 120a, 620) und zwischen Fotodioden (113, 115, 117) oder Fotogates (114) disponiert ist, wobei:
die integrierte flache Grabenisolationsstruktur (T2-T4, 621, 622, 116) ein dielektrisches Material (510) umfasst, das eine erste Dielektrizitätskonstante aufweist;
die lichtempfindliche Halbleiterschicht (111), die die integrierte flache Grabenisolationsstruktur (T2-T4, 621, 622, 116) umgibt, eine zweite Dielektrizitätskonstante aufweist, die von der ersten Dielektrizitätskonstante verschieden ist;
die integrierte flache Grabenisolationsstruktur (T2-T4, 621, 622, 116) und die lichtempfindliche Halbleiterschicht (111) ein optisches Gitter bereitstellen; und
das optische Gitter konfiguriert ist, um das einfallende Licht an der Grenzfläche zwischen der integrierten flachen Grabenisolationsstruktur (T2-T4, 621, 622, 116) und der lichtempfindlichen Halbleiterschicht (111) zumindest eines von zu beugen, abzulenken oder zu reflektieren und um das einfallende Licht innerhalb der lichtempfindlichen Halbleiterschicht (111) umzuverteilen, um eine optische Empfindlichkeit eine Pixels zu verbessern,
wobei der CMOS-Bildsensor weiter einen Dotierstoff (102c, 103c, 104c, 105c) innerhalb der lichtempfindlichen Halbleiterschicht (111) benachbart zu den Wänden (540) der integrierten flachen Grabenisolationsstruktur (T2-T4, 621, 622, 116) umfasst, der konfiguriert ist, um Seitenwände (540) der integrierten flachen Grabenisolationsstruktur (T2-T4, 621, 622, 116) zu passivieren, was zu einem Pixel mit niedrigem Dunkelstrom führt.

2. CMOS-Bildsensor nach Anspruch 1, wobei:
die integrierte flache Grabenisolationsstruktur (T2-T4, 621, 622, 116) zu einer Vielzahl von integrierten flachen Grabenisolationsstrukturen (T2-T4, 621, 622, 116) gehört, die in einem CMOS-Prozess hergestellt sind und in einem eindimensionalen oder einem zweidimensionalen optischen Gitter konfiguriert sind, um das das einfallende Licht innerhalb der lichtempfindlichen Halbleiterschicht (111) umzuverteilen.

3. CMOS-Bildsensor nach Anspruch 1 oder 2, wobei:
die integrierte flache Grabenisolationsstruktur (T2-T4, 621, 622, 116) zu einer Vielzahl von integrierten flachen Grabenisolationsstrukturen (T2-T4, 621, 622, 116) gehört, die in gleichmäßigen Reihen (T2-T4) angeordnet sind.

4. CMOS-Bildsensor nach Anspruch 1 oder 2, wobei:
die integrierte flache Grabenisolationsstruktur (T2-T4, 621, 622, 116) zu einer Vielzahl von integrierten flachen Grabenisolationsstrukturen (T2-T4, 621, 622, 116) gehört, die in ungleichmäßigen Reihen (R1-R7) angeordnet sind.

5. CMOS-Bildsensor nach einem der Ansprüche 1 bis 4, wobei:
das Pixel entweder in einem Vorderseiten-Beleuchtungszustand oder in einem Rückseiten-Beleuchtungszustand mit oder ohne eine integrierte Mikrolinse (601, 601a) konfiguriert ist.

6. CMOS-Bildsensor nach einem der Ansprüche 1 bis 5, wobei:
das Pixel in einem Rückseiten-Beleuchtungszustand mit einer integrierten Mikrolinse (601a) konfiguriert ist;
die integrierte flache Grabenisolationsstruktur (621) zu einer Vielzahl von integrierten flachen Grabenisolationsstrukturen (621) gehört, die auf einer Seite (615) der Epitaxialschicht (620), die von der integrierten Mikrolinse (601a) abgewandt ist, bereitgestellt sind; und
eine zusätzliche integrierte flache Grabenisolationsstruktur (622), die zu einer Vielzahl von integrierten flachen Grabenisolationsstrukturen (622) gehört, die auf einer gegenüberliegenden Seite (616) der Epitaxialschicht (620), die der integrierten Mikrolinse (601a) zugewandt ist, bereitgestellt sind.

7. CMOS-Bildsensor nach einem der Ansprüche 1 bis 6, wobei:
das Pixel in einem Rückseiten-Beleuchtungszustand mit einer integrierten Mikrolinse (601a) konfiguriert ist; und
die integrierte flache Grabenisolationsstruktur (621) zu einer Vielzahl von integrierten flachen Grabenisolationsstrukturen (621) gehört, die auf einer Seite (615) der Epitaxialschicht (620), die von der integrierten Mikrolinse (601a) abgewandt ist, bereitgestellt sind.

8. CMOS-Bildsensor nach einem der Ansprüche 1 bis 6, wobei:
das Pixel in einem Rückseiten-Beleuchtungszustand mit einer integrierten Mikrolinse (601a) konfiguriert ist; und
die integrierte flache Grabenisolationsstruktur (622) zu einer Vielzahl von integrierten flachen Grabenisolationsstrukturen (622) gehört, die auf einer Seite (616) der Epitaxialschicht (620), die der integrierten Mikrolinse (601a) zugewandt ist, bereitgestellt sind.

9. CMOS-Bildsensor nach einem der Ansprüche 1 bis 8, wobei:
die Epitaxialschicht (220a, 120a, 620) mit einem Dotierungsgradienten mit höherer Dotierung tiefer in der Epitaxialschicht und geringerer Dotierung an einer Oberfläche der Epitaxialschicht für eine viel schnellere Ladungssammlung konfiguriert ist.

10. Verfahren zur Herstellung eines CMOS-Bildsensors mit verbesserter optischer Empfindlichkeit, wobei das Verfahren umfasst:
Bereitstellen einer lichtempfindlichen Halbleiterschicht (111), die eine Epitaxialschicht (220a, 120a, 620) umfasst, wobei die Epitaxialschicht (220a, 120a, 620) eine Vielzahl von Fotodioden (113, 115, 117) oder Fotogates (114) umfasst, um einfallendes Licht in elektrische Ladungen umzuwandeln; und
Bereitstellen einer integrierten flachen Grabenisolationsstruktur (T2-T4, 621, 622, 116), die in der Epitaxialschicht (220a, 120a, 620) und zwischen Fotodioden (113, 115, 117) oder Fotogates (114) disponiert ist, wobei:
die integrierte flache Grabenisolationsstruktur (T2-T4, 621, 622, 116) ein dielektrisches Material (510) umfasst, das eine erste Dielektrizitätskonstante aufweist;
die lichtempfindliche Halbleiterschicht (111), die die integrierte flache Grabenisolationsstruktur (T2-T4, 621, 622, 116) umgibt, eine zweite Dielektrizitätskonstante aufweist, die von der ersten Dielektrizitätskonstante verschieden ist;
die integrierte flache Grabenisolationsstruktur (T2-T4, 621, 622, 116) und die lichtempfindliche Halbleiterschicht (111) ein optisches Gitter bereitstellen; und
das optische Gitter konfiguriert ist, um das einfallende Licht an der Grenzfläche zwischen der integrierten flachen Grabenisolationsstruktur (T2-T4, 621, 622, 116) und der lichtempfindlichen Halbleiterschicht (111) zumindest eines von zu beugen, abzulenken oder zu reflektieren und um das einfallende Licht innerhalb der lichtempfindlichen Halbleiterschicht (111) umzuverteilen, um eine optische Empfindlichkeit eine Pixels zu verbessern,
wobei der CMOS-Bildsensor weiter einen Dotierstoff (102c, 103c, 104c, 105c) innerhalb der lichtempfindlichen Halbleiterschicht (111) benachbart zu den Wänden (540) der integrierten flachen Grabenisolationsstruktur (T2-T4, 621, 622, 116) umfasst, der konfiguriert ist, um Seitenwände (540) der integrierten flachen Grabenisolationsstruktur (T2-T4, 621, 622, 116) zu passivieren, was zu einem Pixel mit niedrigem Dunkelstrom führt.

11. Verfahren nach Anspruch 10, wobei:
die integrierte flache Grabenisolationsstruktur (T2-T4, 621, 622, 116) innerhalb einer einzelnen Fotodiodenstruktur (115) positioniert wird oder zu einer Vielzahl von integrierten flachen Grabenisolationsstrukturen (T2-T4, 621, 622, 116) gehört, die abwechselnd mit Fotodiodenstrukturen (117) oder Fotogatestrukturen (114) in dem Substrat (220, 120) positioniert werden.

12. Verfahren nach Anspruch 10 oder 11, weiter umfassend:
Implantieren (401) von Dotierstoffen, um dotierte Bereiche (102d-105d) in dem Epitaxialabschnitt (220a, 120a) des Substrats (220, 120) zu bilden; und
Erwärmen (406) des Substrats (220, 120), um zu bewirken, dass die Dotierstoffe der dotierten Bereiche (102d-105d) lateral in den Epitaxialabschnitt (220a, 120a) des Substrats (220, 120) der integrierten flachen Grabenisolationsstruktur (T2-T4, 621, 622, 116) diffundieren.

## Revendications

1. Capteur d'image CMOS, comprenant :
une couche à semi-conducteur photosensible (111) comprenant une couche épitaxiale (220a, 120a, 620), la couche épitaxiale (220a, 120a, 620) comprenant une pluralité de photodiodes (113, 115, 117) ou des grilles photoniques (114) pour convertir une lumière incidente en charges électriques ; et
une structure d'isolation de tranchée peu profonde intégrée (T2-T4, 621, 622, 116) disposée dans la couche épitaxiale (220a, 120a, 620) et entre des photodiodes (113, 115, 117) ou des grilles photoniques (114), dans lequel :
la structure d'isolation de tranchée peu profonde intégrée (T2-T4, 621, 622, 116) comprend un matériau diélectrique (510) ayant une première constante diélectrique ;
la couche à semi-conducteur photosensible (111), qui entoure la structure d'isolation de tranchée peu profonde intégrée (T2-T4, 621, 622, 116), a une seconde constante diélectrique qui est différente de la première constante diélectrique ;
la structure d'isolation de tranchée peu profonde intégrée (T2-T4, 621, 622, 116) et la couche à semi-conducteur photosensible (111) fournissent un réseau optique ; et
le réseau optique est configuré pour au moins l'une parmi la diffraction, la déviation ou la réflexion de la lumière incidente au niveau de l'interface entre la structure d'isolation de tranchée peu profonde intégrée (T2-T4, 621, 622, 116) et la couche à semi-conducteur photosensible (111) et pour la redistribution de la lumière incidente à l'intérieur de la couche à semi-conducteur photosensible (111) pour améliorer une sensibilité optique d'un pixel,
dans lequel le capteur d'image CMOS comprend en outre un dopant (102c, 103c, 104c, 105c) à l'intérieur de la couche à semi-conducteur photosensible (111) adjacent aux parois (540) de la structure d'isolation de tranchée peu profonde intégrée (T2-T4, 621, 622, 116) qui est configuré pour passiver des parois latérales (540) de la structure d'isolation de tranchée peu profonde intégrée (T2-T4, 621, 622, 116), donnant lieu à un pixel avec un faible courant d'obscurité.

2. Capteur d'image CMOS selon la revendication 1, dans lequel :
la structure d'isolation de tranchée peu profonde intégrée (T2-T4, 621, 622, 116) se trouve parmi une pluralité de structures d'isolation de tranchée peu profondes intégrées (T2-T4, 621, 622, 116) qui sont fabriquées dans un processus CMOS et qui sont configurées dans un réseau optique unidimensionnel ou bidimensionnel pour redistribuer la lumière incidente à l'intérieur de la couche à semi-conducteur photosensible (111).

3. Capteur d'image CMOS selon la revendication 1 ou 2, dans lequel :
la structure d'isolation de tranchée peu profonde intégrée (T2-T4, 621, 622, 116) se trouve parmi une pluralité de structures d'isolation de tranchée peu profondes intégrées (T2-T4, 621, 622, 116) qui sont agencées en rangées uniformes (T2-T4).

4. Capteur d'image CMOS selon la revendication 1 ou 2, dans lequel :
la structure d'isolation de tranchée peu profonde intégrée (T2-T4, 621, 622, 116) se trouve parmi une pluralité de structures d'isolation de tranchée peu profondes intégrées (T2-T4, 621, 622, 116) qui sont agencées en rangées non-uniformes (R1-R7).

5. Capteur d'image CMOS selon l'une quelconque des revendications 1 à 4, dans lequel :
le pixel est configuré dans soit une condition d'éclairage avant soit une condition d'éclairage arrière avec ou sans microlentille intégrée (601, 601a).

6. Capteur d'image CMOS selon l'une quelconque des revendications 1 à 5, dans lequel :
le pixel est configuré dans une condition d'éclairage arrière avec une microlentille intégrée (601a) ;
la structure d'isolation de tranchée peu profonde intégrée (621) se trouve parmi une pluralité de structures d'isolation de tranchée peu profondes intégrées (621) qui sont prévues sur un côté (615) de la couche épitaxiale (620) qui est tourné à l'opposé de la microlentille intégrée (601a) ; et
une structure d'isolation de tranchée peu profonde intégrée supplémentaire (622) se trouve parmi une pluralité de structures d'isolation de tranchée peu profondes intégrées (622) qui sont prévues sur un côté opposé (616) de la couche épitaxiale (620) qui est tourné vers la microlentille intégrée (601a).

7. Capteur d'image CMOS selon l'une quelconque des revendications 1 à 6, dans lequel :
le pixel est configuré dans une condition d'éclairage arrière avec une microlentille intégrée (601a) ; et
la structure d'isolation de tranchée peu profonde intégrée (621) se trouve parmi une pluralité de structures d'isolation de tranchée peu profondes intégrées (621) qui sont prévues sur un côté (615) de la couche épitaxiale (620) qui est tourné à l'opposé de la microlentille intégrée (601a).

8. Capteur d'image CMOS selon l'une quelconque des revendications 1 à 6, dans lequel :
le pixel est configuré dans une condition d'éclairage arrière avec une microlentille intégrée (601a) ; et
la structure d'isolation de tranchée peu profonde intégrée (622) se trouve parmi une pluralité de structures d'isolation de tranchée peu profondes intégrées (622) qui sont prévues sur un côté (616) de la couche épitaxiale (620) qui est tourné vers la microlentille intégrée (601a).

9. Capteur d'image CMOS selon l'une quelconque des revendications 1 à 8, dans lequel :
la couche épitaxiale (220a, 120a, 620) est configurée avec un gradient de dopage avec un dopage plus élevé plus profond dans la couche épitaxiale et un dopage plus faible au niveau d'une surface de la couche épitaxiale pour une collecte de charge beaucoup plus rapide.

10. Procédé de fabrication d'un capteur d'image CMOS avec une sensibilité optique améliorée, le procédé comprenant :
la fourniture d'une couche à semi-conducteur photosensible (111) comprenant une couche épitaxiale (220a, 120a, 620), la couche épitaxiale (220a, 120a, 620) comprenant une pluralité de photodiodes (113, 115, 117) ou de grilles photoniques (114) pour convertir une lumière incidente en charges électriques ; et
la fourniture d'une structure d'isolation de tranchée peu profonde intégrée (T2-T4, 621, 622, 116) disposée dans la couche épitaxiale (220a, 120a, 620) et entre des photodiodes (113, 115, 117) ou des grilles photoniques (114), dans lequel :
la structure d'isolation de tranchée peu profonde intégrée (T2-T4, 621, 622, 116) comprend un matériau diélectrique (510) ayant une première constante diélectrique ;
la couche à semi-conducteur photosensible (111), qui entoure la structure d'isolation de tranchée peu profonde intégrée (T2-T4, 621, 622, 116), a une seconde constante diélectrique qui est différente de la première constante diélectrique ;
la structure d'isolation de tranchée peu profonde intégrée (T2-T4, 621, 622, 116) et la couche à semi-conducteur photosensible (111) fournissent un réseau optique ; et
le réseau optique est configuré pour au moins l'une parmi la diffraction, la déviation ou la réflexion de la lumière incidente au niveau de l'interface entre la structure d'isolation de tranchée peu profonde intégrée (T2-T4, 621, 622, 116) et la couche à semi-conducteur photosensible (111) et pour la redistribution de la lumière incidente à l'intérieur de la couche à semi-conducteur photosensible (111) pour améliorer une sensibilité optique d'un pixel,
dans lequel le capteur d'image CMOS comprend en outre un dopant (102c, 103c, 104c, 105c) à l'intérieur de la couche à semi-conducteur photosensible (111) adjacent aux parois (540) de la structure d'isolation de tranchée peu profonde intégrée (T2-T4, 621, 622, 116) qui est configuré pour passiver des parois latérales (540) de la structure d'isolation de tranchée peu profonde intégrée (T2-T4, 621, 622, 116), donnant lieu à un pixel avec un faible courant d'obscurité.

11. Procédé selon la revendication 10, dans lequel :
la structure d'isolation de tranchée peu profonde (T2-T4, 621, 622, 116) est positionnée à l'intérieur d'une unique structure de photodiode (115) ou se trouve parmi une pluralité de structures d'isolation de tranchée peu profondes (T2-T4, 621, 622, 116) qui sont positionnées en alternance avec les structures de photodiode (117) ou les structures de grille photonique (114) dans le substrat (220, 120).

12. Procédé selon la revendication 10 ou 11, comprenant en outre :
l'implantation (401) de dopants pour former des régions dopées (102d-105d) dans la partie épitaxiale (220a, 120a) du substrat (220, 120) ; et
le chauffage (406) du substrat (220, 120) pour amener les dopants des régions dopées (102d-105d) à se diffuser latéralement dans la partie épitaxiale (220a, 120a) du substrat (220, 120) de la structure d'isolation de tranchée peu profonde (T2-T4, 621, 622, 116).
